# EUROPEAN PATENT APPLICATION

(11) **EP 1 553 112 A1**
(43) Date of publication of application: **13.07.2005**
(21) Application number: 03754122.4
(22) Date of filing: 15.10.2003
(51) Int. Cl.: C08F 214/18, C08F 4/34

(54) **PROCESS FOR PRODUCTION OF FLUOROPOLYMERS AND PHOTORESIST COMPOSITION**

(30) Priority: 18.10.2002 JP 2002304891
(71) Applicant: Daikin Industries, Ltd., Osaka-shi, Osaka 530-8323 (JP)
(72) Inventor: ARAKI, Takayuki; c/o Yodogawa-seisakusho, Settsu-shi, Osaka 566-8585 (JP); ISHIKAWA, Takuji; c/o Yodogawa-seisakusho, Settsu-shi, Osaka 566-8585 (JP); KOH, Meiten; c/o Yodogawa-seisakusho, Settsu-shi, Osaka 566-8585 (JP); TORIUMI, Minoru, Tachikawa-shi, Tokyo 190-0002 (JP)
(74) Representative: HOFFMANN EITLE
(86) International application number: PCT/JP2003/013161
(87) International publication number: WO 2004/035641

(57) **Abstract**

There is provided a process for preparing a fluorine-containing polymer for resist which is excellent in transparency in a vacuum ultraviolet region, comprises a structural unit derived from a fluorine-containing ethylenic monomer and/or a structural unit derived from a monomer which can provide an aliphatic ring structure in the polymer trunk chain and may have a fluorine atom, and has an acid-reactive group Y¹ reacting with an acid or a group Y² which can be converted to the acid-reactive group Y¹, in which the fluorine-containing ethylenic monomer and/or the monomer which can provide an aliphatic ring structure in the polymer trunk chain are subjected to radical polymerization by using an organic peroxide represented by the formula (1): 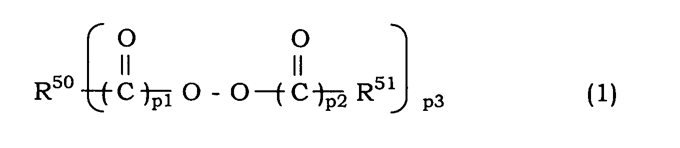 wherein R⁵⁰ and R⁵¹ are the same or different and each is a hydrocarbon group having 1 to 30 carbon atoms which may have ether bond (an atom at an end of bond is not oxygen atom); p1 and p2 are the same or different and each is 0 or 1; p3 is 1 or 2, and also there is provided a photoresist composition comprising the obtained polymer. The fluorine-containing polymer is excellent in transparency in a vacuum ultraviolet region, and can form an ultra fine pattern as a polymer for a photoresist, particularly for a F2 resist.

## Description

### TECHNICAL FIELD

The present invention relates to a novel process for preparing a fluorine-containing polymer, further a process for preparing a fluorine-containing polymer for photoresist being transparent to light in a vacuum ultraviolet region, particularly F2 laser (157 nm) and relates to a photoresist composition comprising the fluorine-containing polymer for photoresist.

### BACKGROUND ART

As a result of an increasing necessity of high integration of a large scale integrated circuit (LSI), microfabrication technology is required for photolithography. In order to satisfy such requirements, there have been tried to use, as exposure light sources, deep ultraviolet, KrF excimer laser (wavelength: 248 nm) and ArF excimer laser (wavelength: 193 nm) which have a wavelength shorter than conventional g-rays (wavelength: 436 nm) and i-rays (wavelength: 365 nm). Those light sources are put into practical use.

Recently a process using F₂ laser (wavelength: 157 nm) in a vacuum ultraviolet region has been studied in an ultra-microfabrication technology and is considered promising as an exposure technology aiming at a technology node of 0.07 µm.

Examples of conventional resins for resist are phenol resins in which a part or the whole of hydroxyl groups are protected by protective groups such as acetal or ketal (KrF resist), methacrylic acid resins in which an acid-labile ester group is introduced to carboxyl group (ArF resist) and the like.

However those conventional resist polymers have strong absorption in a wavelength range of vacuum ultraviolet region and have a significant problem that transparency is low (absorption coefficient is high) in F₂ laser having a wavelength of 157 nm which is studied for use in a process for ultra fine pattern. Therefore in order to expose with F₂ laser, it is necessary to make a resist film thickness extremely thin and it is substantially difficult to use the polymers as a single layer F₂ resist.

Accordingly resists prepared from a fluorine-containing polymer having high transparency to F₂ laser are studied.

Among them, fluorine-containing polymers prepared by copolymerizing a fluoroolefin having 2 or 3 carbon atoms which is represented by tetrafluoroethylene or the like and/or fluorine-containing polymers having a ring structure in a trunk chain thereof are preferred from the viewpoint of both of transparency and dry etching resistance and are useful as a resist polymer.

There have been proposed fluorine-containing polymers for resist having functional group reacting with an acid and photoresist compositions prepared therefrom (for example, cf. International Publication No. WO00/ 17712, International Publication No. WO00/67072 and International Publication No. WO01/74916).

Those patent publications concretely disclose copolymers comprising a fluoroolefin represented by tetrafluoroethylene and an alicyclic monomer represented by norbornene (or norbornene derivative), in which the fluoroolefin and the alicyclic monomer are subjected to radical polymerization by using an organic peroxide of peroxydicarbonate as a polymerization initiator.

However fluorine-containing polymers obtained by those preparation processes disclosed therein are insufficient in transparency in a vacuum ultraviolet region.

Also fluorine-containing polymers are inherently high in water repellency and solubility thereof in a developing solution after exposure is easily lowered. As a result, developing characteristics and resolution are easily lowered.

The present inventors have made intensive studies in the light of those problems, and have found that in preparing a fluorine-containing polymer for photoresist having an acid-reactive group by radical (co)polymerization of a fluoroolefin with a monomer forming a ring structure in the polymer trunk chain, the fluorine-containing polymer for photoresist can be obtained effectively and transparency of the fluorine-containing polymer to F₂ laser can be enhanced when carrying out radical (co)polymerization using a specific radical polymerization initiator.

Also the present inventors have found at the same time that dissolution characteristics in a developing solution after exposure are remarkably enhanced, and developing characteristics and resolution are improved.

Further the present inventors have found that the above-mentioned preparation process of a fluorine-containing polymer for photoresist is effective not only for a resist but also for polymerization of a monomer forming a ring structure in the polymer trunk chain.

The first object of the present invention is to provide a process for preparing a specific fluorine-containing polymer by radical (co)polymerization of a monomer forming a ring structure in its trunk chain and further as case demands, other comonomer by using a specific radical polymerization initiator.

The second object of the present invention is to provide a process for preparing a fluorine-containing polymer being excellent in transparency to F2 laser, particularly a fluorine-containing polymer for resist by radical (co)polymerization of a fluoroolefin, a monomer forming a ring structure in a trunk chain and further as case demands, other comonomer by using a specific kind of radical polymerization initiator.

The third object of the present invention is to provide a process for preparing a fluorine-containing polymer being excellent in transparency to F2 laser, particularly a fluorine-containing polymer for resist by radical (co)polymerization of a fluoroolefin, a monomer forming a ring structure in a trunk chain and further as case demands, other comonomer by using a specific another kind of radical polymerization initiator.

The fourth object of the present invention is to provide a photoresist composition, particularly a photoresist composition for F2 comprising the fluorine-containing polymer for resist which is obtained by the mentioned preparation processes and is excellent in developing characteristics in a vacuum ultraviolet light.

### DISCLOSURE OF INVENTION

The first of the present invention relates to a process for preparing a fluorine-containing polymer having a structural unit (M1) derived from a monomer (m1) which can provide an aliphatic ring structure in the polymer trunk chain and may have fluorine atom, in which the monomer (m1) being capable of providing an aliphatic ring structure in the polymer trunk chain is subjected to radical polymerization by using an organic peroxide (hereinafter referred to as "the first kind of organic peroxide") having a structural unit represented by the formula (1-1): 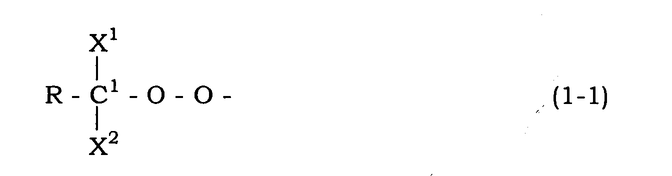 wherein R is selected from monovalent hydrocarbon groups having 3 or more carbon atoms, in which hydrogen atom may be substituted with fluorine atom or monovalent hydrocarbon groups having ether bond, in which the total number of carbon atoms and oxygen atoms is 3 or more and hydrogen atom may be substituted with fluorine atom, and when in R, carbon atoms or carbon atoms and oxygen atoms in the case of having ether bond are counted from the carbon atom C¹, at least one of the fourth atoms is a carbon atom to which at least one hydrogen atom is bonded; X¹ and X² are the same or different and each is hydrogen atom, halogen atom or a hydrocarbon group having 1 to 10 carbon atoms, in which a part or the whole of hydrogen atoms may be substituted with fluorine atoms,
or the formula (1-2): 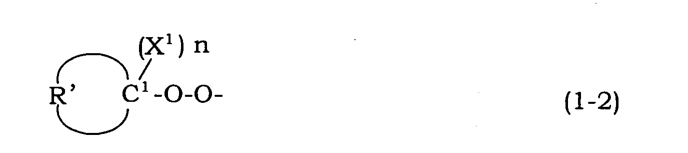 wherein R' is selected from divalent hydrocarbon groups having 4 or more carbon atoms, in which hydrogen atom may be substituted with fluorine atom or divalent hydrocarbon groups having ether bond, in which the total number of carbon atoms and oxygen atoms is 4 or more and hydrogen atom may be substituted with fluorine atom, and when in R', carbon atoms or carbon atoms and oxygen atoms in the case of having ether bond are counted from the carbon atom C¹, at least one of the fourth atoms is a carbon atom to which at least one hydrogen atom is bonded; X¹ is hydrogen atom, halogen atom or a hydrocarbon group having 1 to 10 carbon atoms, in which a part or the whole of hydrogen atoms may be substituted with fluorine atoms; n is 0 or 1.

The second of the present invention relates to a process for preparing a fluorine-containing polymer for resist which comprises a structural unit (M2) derived from a fluorine-containing ethylenic monomer (m2) having 2 or 3 carbon atoms and at least one fluorine atom and/or a structural unit (M3) derived from a monomer (m3) which can provide an aliphatic ring structure in the polymer trunk chain and may have fluorine atom, and has an acid-reactive group Y¹ reacting with an acid or a group Y² which can be converted to the acid-reactive group Y¹, in which the process is characterized in that the fluorine-containing ethylenic monomer (m2) and/or the monomer (m3) which can provide an aliphatic ring structure in the polymer trunk chain are subjected to radical polymerization by using the first kind of organic peroxide having a structural unit represented by the above-mentioned formula (1-1) or (1-2).

The preparation process of the present invention not only can make a molecular weight of the polymer high since the polymerization reaction advances rapidly but also provides the fluorine-containing polymer being excellent in transparency to light in a vacuum ultraviolet region and developing characteristics.

The third of the present invention relates to a process for preparing a fluorine-containing polymer for resist being excellent in transparency in a vacuum ultraviolet region which comprises a structural unit (M2) derived from a fluorine-containing ethylenic monomer (m2) having 2 or 3 carbon atoms and at least one fluorine atom and/or a structural unit (M3) derived from a monomer (m3) which can provide an aliphatic ring structure in the polymer trunk chain and may have fluorine atom, and has an acid-reactive group Y¹ reacting with an acid or a group Y² which can be converted to the acid-reactive group Y¹, in which the process is characterized in that the fluorine-containing ethylenic monomer (m2) and/or the monomer (m3) which can provide an aliphatic ring structure in the polymer trunk chain are subjected to radical polymerization by using an organic peroxide (hereinafter referred to as "the second kind of organic peroxide") represented by the formula (1): 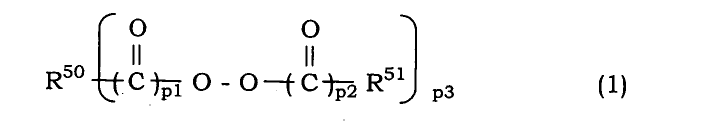 wherein R⁵⁰ and R⁵¹ are the same or different and each is a hydrocarbon group having 1 to 30 carbon atoms which may have ether bond (an atom at an end of bond is not oxygen atom); p1 and p2 are the same or different and each is 0 or 1; p3 is 1 or 2.

The fourth of the present invention relates to a photoresist composition which comprises:
(A-1) a fluorine-containing polymer having at least one of acid-reactive groups Y¹ including OH group, an acid-labile functional group which can be converted to OH group by an acid, COOH group and an acid-labile functional group which can be converted to COOH group by dissociation with an acid,
(B) a photoacid generator, and
(C) a solvent,
in which the fluorine-containing polymer (A-1) is the fluorine-containing polymer for resist obtained by the second or third preparation process of the present invention.

The photoresist composition provides a resist film being excellent in transparency to vacuum ultraviolet light and developing characteristics (particularly solubility in a developing solution) and is useful particularly for the use for an ultra-microfabrication process.

### BEST MODE FOR CARRYING OUT THE INVENTION

The fluorine-containing polymer (hereinafter referred to as "the first fluorine-containing polymer") prepared by the first preparation process of the present invention is a fluorine-containing polymer having a structural unit (M1) derived from a monomer (m1) which can provide an aliphatic ring structure in the polymer trunk chain and may have fluorine atom. Further the fluorine-containing polymer may contain a structural unit (N1) derived from an optional comonomer (n1) copolymerizable with the monomer (m1).

The fluorine atom in the first fluorine-containing polymer obtained in the present invention is not limited to one derived from the monomer (m1) and may be one derived from the other optional comonomer (n1) . Namely, the monomer (m1) may not have fluorine atom when a fluorine-containing monomer is used as the comonomer (n1).

The fluorine-containing polymer (hereinafter referred to as "the second fluorine-containing polymer") prepared by the second preparation process of the present invention is a fluorine-containing polymer which comprises the structural unit (M2) derived from the fluorine-containing ethylenic monomer (m2) having 2 or 3 carbon atoms and at least one fluorine atom and/or the structural unit (M3) derived from the monomer (m3) which can provide an aliphatic ring structure in the polymer trunk chain and may have fluorine atom, and has an acid-reactive group Y¹ reacting with an acid or a group Y² which can be converted to the acid-reactive group Y¹ (hereinafter Y² may be referred to as "group Y² convertible to an acid-reactive group", and both of Y¹ and Y² may be referred to as "acid-reactive functional group Y"). The polymer may further contain a structural unit (N2) derived from an optional comonomer (n2).

The fluorine atom in the fluorine-containing polymer obtained in the present invention is not always limited to one derived from the monomer (m2) or the monomer (m3) like the first invention and may be one derived from the other optional comonomer (n2). Namely, the monomer (m2) and/or the monomer (m3) may not have fluorine atom when a fluorine-containing monomer is used as the comonomer (n2).

The fluorine-containing polymer (hereinafter referred to as "the third fluorine-containing polymer") prepared by the third preparation process of the present invention is a fluorine-containing polymer which comprises either one or both of the structural unit (M2) derived from the fluorine-containing ethylenic monomer (m2) and the structural unit (M3) derived from the monomer (m3) which can provide an aliphatic ring structure in the polymer trunk chain and may have fluorine atom, and has the acid-reactive group Y¹ or the group Y² convertible to an acid-reactive group. The polymer may further contain the optional structural unit (N2).

The fluorine atom in the third fluorine-containing polymer obtained in the present invention is not always limited to one derived from the monomer (m2) or the monomer (m3) and may be one derived from the other optional comonomer. Namely, the monomer (m2) and/or the monomer (m3) may not have fluorine atom when a fluorine-containing monomer is used as the comonomer (n2).

The methods for introducing the acid-reactive functional group Y to the polymer are explained infra in detail, and there are:
(I) a method of copolymerizing monomers having the acid-reactive functional group Y as the monomer (m2) and/or the monomer (m3),
(II) a method of copolymerizing a monomer (n2-1) having the acid-reactive functional group Y other than the monomer (m2) and the monomer (m3),
   and the like method.

Explained below are firstly the first kind of radical polymerization initiator, secondly the second kind of radical polymerization initiator and then each monomer subjected to radical polymerization.

The first and second preparation processes of the present invention are characterized in that for preparing the first and second fluorine-containing polymers, radical polymerization is carried out by using the first kind of organic peroxide having the structural unit represented by the formula (1-1): 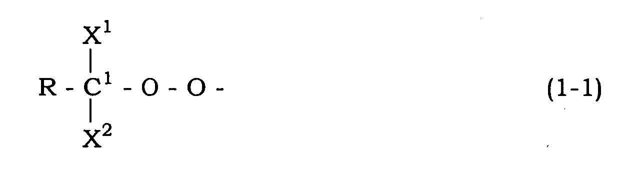 wherein R is selected from monovalent hydrocarbon groups having 3 or more carbon atoms in which hydrogen atom may be substituted with fluorine atom or monovalent hydrocarbon groups having ether bond, in which the total number of carbon atoms and oxygen atoms is 3 or more and hydrogen atom may be substituted with fluorine atom, and when in R, carbon atoms or carbon atoms and oxygen atoms in the case of having ether bond are counted from the carbon atom C¹, at least one of the fourth atoms is a carbon atom to which at least one hydrogen atom is bonded; X¹ and X² are the same or different and each is hydrogen atom, halogen atom or a hydrocarbon group having 1 to 10 carbon atoms, in which a part or the whole of hydrogen atoms may be substituted with fluorine atoms,
or the formula (1-2): 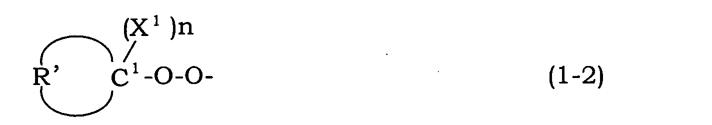 wherein R' is selected from divalent hydrocarbon groups having 4 or more carbon atoms, in which hydrogen atom may be substituted with fluorine atom or divalent hydrocarbon groups having ether bond, in which the total number of carbon atoms and oxygen atoms is 4 or more and hydrogen atom may be substituted with fluorine atom, and when in R', carbon atoms or carbon atoms and oxygen atoms in the case of having ether bond are counted from the carbon atom C¹, at least one of the fourth atoms is a carbon atom to which at least one hydrogen atom is bonded; X¹ is hydrogen atom, halogen atom or a hydrocarbon group having 1 to 10 carbon atoms, in which a part or the whole of hydrogen atoms may be substituted with fluorine atoms; n is 0 or 1.

When the first kind of organic peroxide is used, reactivity of the radical polymerization of a fluorine-containing monomer is enhanced, and surprisingly hydrophilic property of the polymer itself is enhanced and particularly solubility of the fluorine-containing polymer having the acid-reactive functional group Y (after exposure or deprotection of protective group) in a developing solution is enhanced.

In other words, it was found that when the hydrocarbon group R and R' bonded to C¹ in the formula (1-1) and (1-2), respectively have a specific structure, hydrophilic property of the fluorine-containing polymer after the polymerization is improved and when the polymer is used particularly for resist application, solubility in a developing solution (after exposure) is enhanced.

Namely, attention is attracted to the carbon-carbon bond or the carbon-oxygen bond in R and R', and R and R' are characterized in that the fourth atom from the carbon atom C¹ is a carbon atom, and to that carbon atom is bonded hydrogen atom.

The formula (1-1) is, for example, 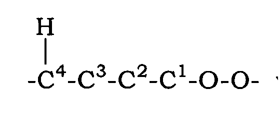 wherein R or R' contains 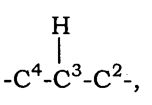 or at least contains a structural unit represented by: 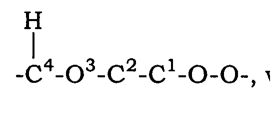 wherein R or R' contains 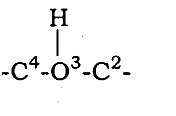 or the like.

In the structural unit of the formula (1-1), there is a necessity of R being "a hydrocarbon group, in which when in R, carbon atoms or carbon atoms and oxygen atoms in the case of having ether bond are counted from the carbon atom C¹, at least one of the fourth atoms is a carbon atom to which at least one hydrogen atom is bonded" in order to make use of the following mechanism.

Namely, it is considered that when there is a hydrogen atom at the specific position (C⁴) in the above-mentioned structure, a part of: 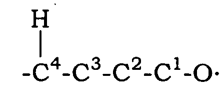 (oxygen radical)
once generated from the organic peroxide easily removes the hydrogen atom bonded to C⁴, and is converted to ·C⁴-C³-C²-C¹ -OH (carbon radical), and because polymerization is initiated or terminated by a radical transferred to C⁴, OH group can be automatically introduced to an end of the obtained fluorine-containing polymer to remarkably enhance hydrophilic property.

This mechanism arises similarly in the structural unit represented by the formula (1-2).

The formula (1-1) shows that the monovalent hydrocarbon R is directly bonded to C¹, and R itself may have a linear, branched or ring structure.

On the other hand, the formula (1-2) shows one having at least a ring structure formed through the divalent hydrocarbon R' and C¹.

It is preferable that in the formula (1-2), the ring structure formed through the divalent hydrocarbon R' and C¹ is a five-membered or six-membered ring structure.

Further with respect to the first kind of organic peroxide, it is preferable that in the formula (1-1), at least one of atomic groups including the third neighboring carbon atom from the atom in R bonded to C¹ is methyl group, in other words, methyl group is bonded to the second neighboring carbon atom (or oxygen atom) from the atom in R bonded to the carbon atom C¹. It is particularly preferable that R in the formula (1-1) is one represented by the formula (1-1a): 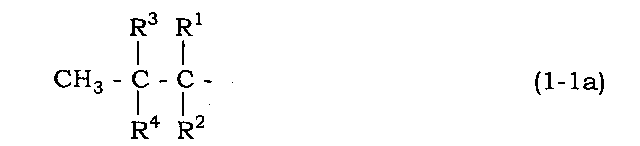 or the formula (1-1b): 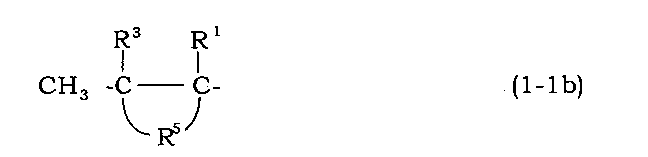 wherein R¹, R², R³ and R⁴ are the same or different and each is hydrogen atom or a hydrocarbon group having 1 to 10 carbon atoms, R⁵ is a divalent hydrocarbon group having 1 to 10 carbon atoms.

Examples of R represented by the formula (1-1a) are: 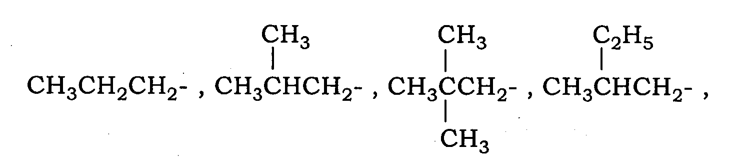 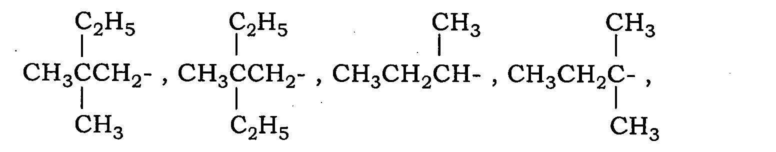 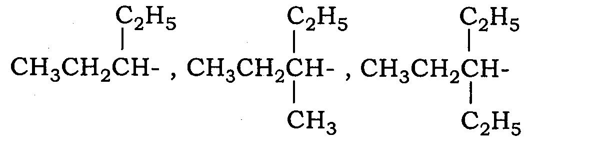 and the like.

Examples of R represented by the formula (1-1b) are: 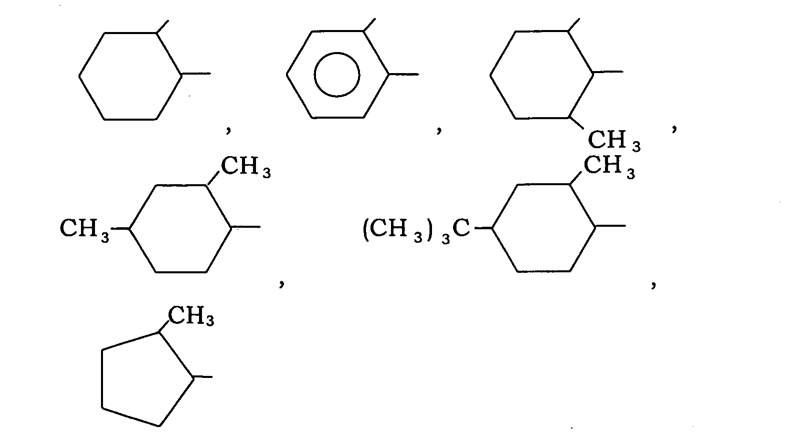 and the like.

Examples of the structure R' including C¹ in the formula (1-2) are: 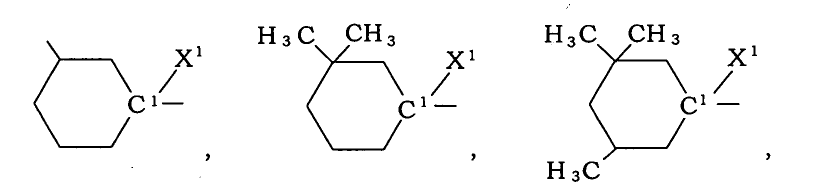 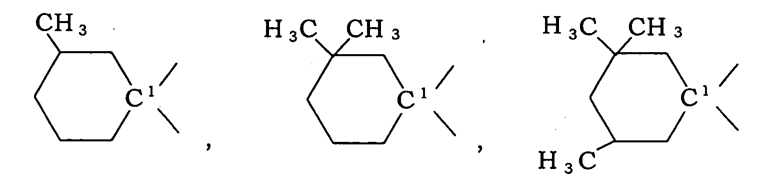 and the like.

In the formulae (1-1) and (1-2), each of X¹ and X² is selected from hydrogen atom, halogen atom and a hydrocarbon group having 1 to 10 carbon atoms, in which a part or the whole of hydrogen atoms may be substituted with fluorine atoms and is preferably selected from hydrogen atom and a hydrocarbon group having 1 to 10 carbon atoms and is particularly preferably hydrogen atom or methyl group.

As far as the first kind of organic peroxides have the above-mentioned structures, any of them can be used. Concretely preferred as an organic peroxide are one or two or more selected from oxyperesters, dialkyl peroxides, peroxy ketals and hydroperoxides.

The first kind of organic peroxides are preferred since transparency in a vacuum ultraviolet region can be enhanced and is also preferred since hydrophilic property can be imparted to the polymer by selecting the specific structure of the present invention, and as a result, developing characteristics can be improved when the polymer is used for resist application.

When preparing a polymer having the structural unit derived from the fluorine-containing ethylenic monomer (m2), it is preferable to use the first kind of organic peroxide having a ten-hour half-life temperature of from 5° to 130°C, more preferably from 15° to 100°C, particularly preferably from 30° to 80°C, from the viewpoint of good polymerization reactivity.

From the viewpoint of good polymerization reactivity and good transparency of the obtained fluorine-containing polymer in a vacuum ultraviolet region, oxyperesters are preferred.

Preferred as the oxyperester are those represented by: 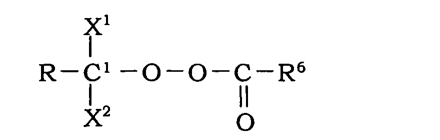 or 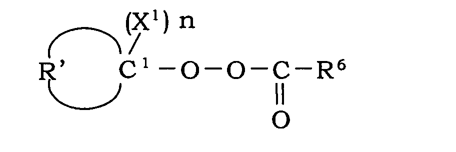 wherein R, R', X¹ and X² are as defined above; R⁶ is selected from monovalent hydrocarbon groups having 1 to 20 carbon atoms, in which hydrogen atom may be substituted with fluorine atom or monovalent hydrocarbon groups having 1 to 20 carbon atoms and ether bond, in which hydrogen atom may be substituted with fluorine atom.

Preferred examples of R, R', X¹ and X² and the structural unit containing them are the same as those exemplified supra.

In the first and second preparation processes of the present invention, preferred examples of the oxyperester are: 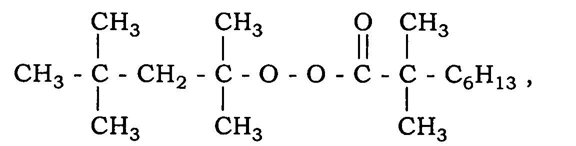 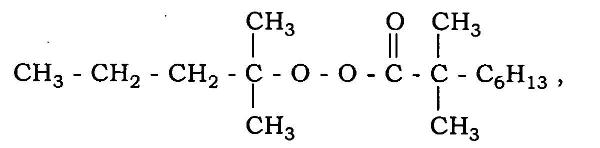 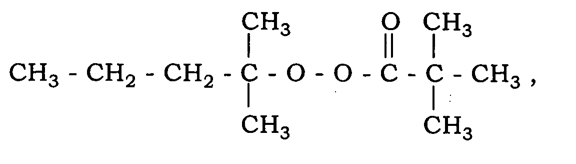 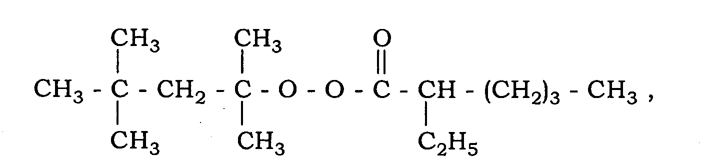 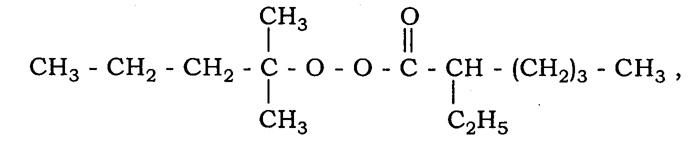 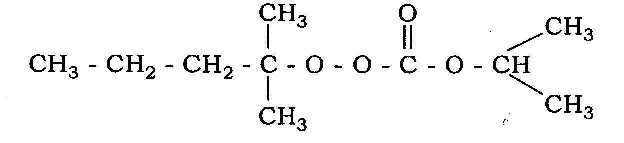 and 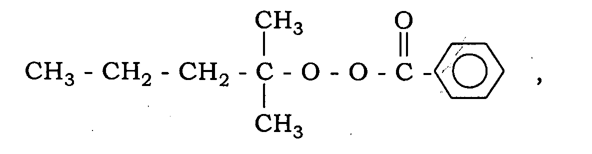 and particularly preferred are: 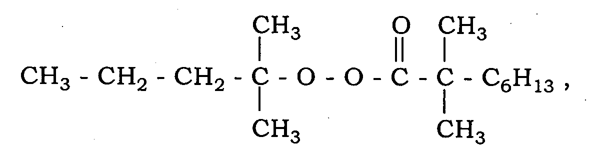 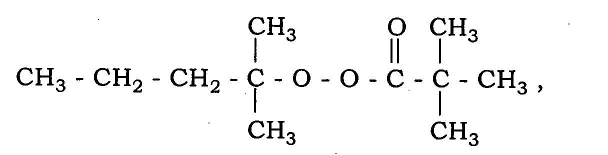 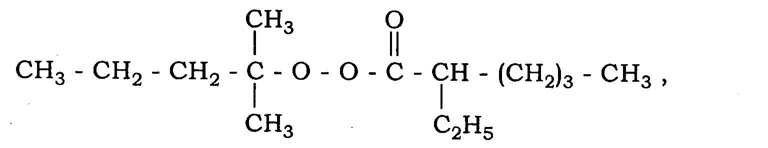 and the like.

The third preparation process of the present invention is
characterized in that for preparing the above-mentioned fluorine-containing polymer, the radical polymerization is carried out by using the second kind of organic peroxide represented by the formula (1): 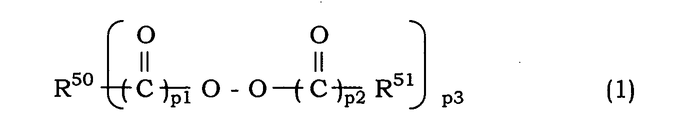 wherein R⁵⁰ and R⁵¹ are the same or different and each is a hydrocarbon group having 1 to 30 carbon atoms which may have ether bond (an atom at an end of bond is not an oxygen atom); p1 and p2 are the same or different and each is 0 or 1; p3 is 1 or 2.

When the second kind of organic peroxide is used, radical polymerization reactivity of a fluorine-containing monomer is enhanced, and further transparency in a vacuum ultraviolet region is enhanced since an atomic group exhibiting small absorption in a vacuum ultraviolet region can be given to the polymer end.

Further it was found that hydrophilic property of the polymer itself is enhanced, and particularly solubility in a developing solution of the fluorine-containing polymer having the acid-reactive functional group Y (after exposure or deprotection of the protective group) is enhanced.

In the second kind of organic peroxide of the formula (1), it is preferable that p3 is 1, one of P1 and P2 is 1 and one of R⁵⁰ and R⁵¹ is a hydrocarbon group having 5 or more carbon atoms which may have ether bond; a hydrocarbon group, in which p3 is 1 and p1 and p2 are 1; at least one of R⁵⁰ and R⁵¹ is a hydrocarbon group having 5 or more carbon atoms which has an aliphatic ring structure; or at least one of R⁵⁰ and R⁵¹ is a hydrocarbon group containing at least one hydrophilic functional group such as OH group or COOH group.

Also R⁵⁰ and R⁵¹ in the formula (1) are the same or different and each is selected from hydrocarbon groups having 1 to 30 carbon atoms which may have ether bond (an atom at an end of bond is not an oxygen atom), and contains neither fluorine atom nor other halogen atom. Particularly preferred are saturated aliphatic hydrocarbon groups (having neither a carbon-carbon double bond nor an aromatic group) from the viewpoint of transparency.

Concretely each of R⁵⁰ and R⁵¹ is selected from linear or branched alkyl groups having 1 to 30 carbon atoms and alkyl groups having an aliphatic ring structure.

It is particularly preferable that at least one of R⁵⁰ and R⁵¹ is an alkyl group having an aliphatic ring structure since dry etching resistance can be improved.

Examples thereof are: 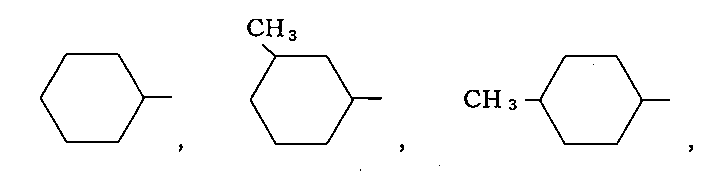 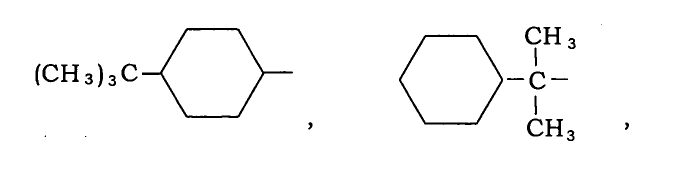 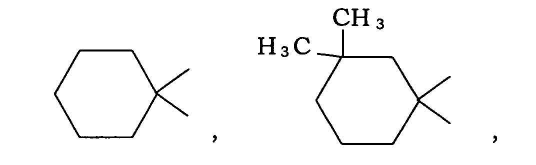 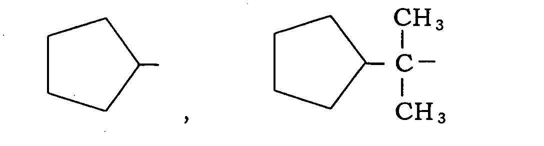 and the like.

Preferred examples of the linear or branched alkyl group are:

CH₃CH₂CH₂- , (CH₃)₂CH- , (CH₃)₃C- , C₇H₁₅- ,

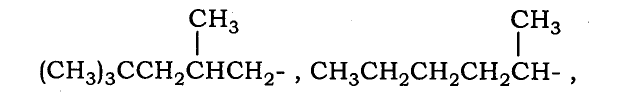

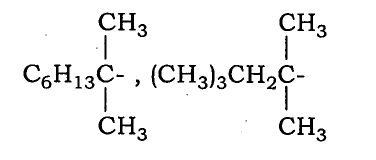

and the like.

Also a part of hydrogen atoms of R⁵⁰ and R⁵¹ may be substituted with functional groups which can impart hydrophilic property.

This substitution is preferred since by an effect of the functional groups, hydrophilic property of the polymer itself is enhanced and solubility in a developing solution of the fluorine-containing polymer having the acid-reactive functional group Y (after exposure or deprotection of the protective group) can be improved.

Examples of the hydrophilic functional group are OH group, COOH group, SO₃H group and the like, and preferred are OH group and COOH group.

Preferred examples of R⁵⁰ (or R⁵¹) are, for instance, - CH₂CH₂COOH and the like.

Preferred examples of the second kind of organic peroxide of the formula (1) are one or two or more selected from diacyl peroxides (p1=p2=1 in the formula (1)), oxyperesters (one of p1 is 1), peroxy ketals (p1=p2=1, p3=2) and dialkyl peroxides (p1=p2=0). Peroxydicarbonates are not encompassed in the second kind of organic peroxides as it is defined that in R⁵⁰ and R⁵¹ of the formula (1), an atom at an end of bond is not an oxygen atom.

Among them, more preferred are oxyperesters (one of p1 is 1) since radical polymerization reaction can be accelerated and transparency of the obtained polymer in a vacuum ultraviolet region can be further improved.

Further oxyperesters are preferred since hydrophilic property of the polymer itself is enhanced and particularly solubility in a developing solution of the fluorine-containing polymer having the acid-reactive functional group Y (after exposure or deprotection of the protective group) is enhanced.

In those oxyperesters, from the viewpoint of good etching resistance, it is preferable that one of R⁵⁰ and R⁵¹ is a hydrocarbon group having 5 or more carbon atoms.

Concretely oxyperesters having an alkyl group such as: 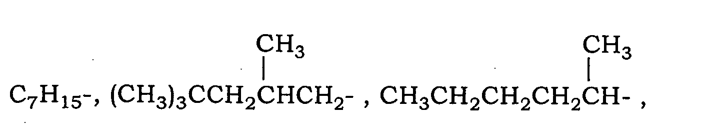 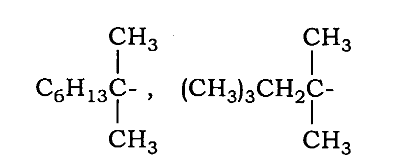 and the like are preferred.

Also it is preferable that one of R⁵⁰ and R⁵¹ is an alkyl group having an aliphatic ring structure since dry etching resistance can be improved, and the above-mentioned examples of an alkyl group having an aliphatic ring structure can be used similarly. For example, there are: 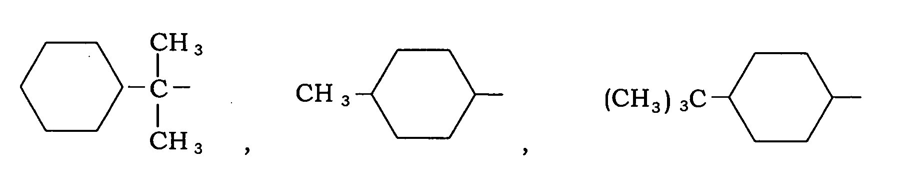 and the like.

Preferred examples of oxyperesters are: 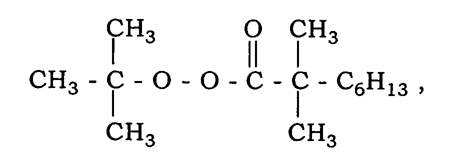 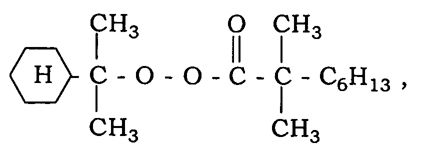 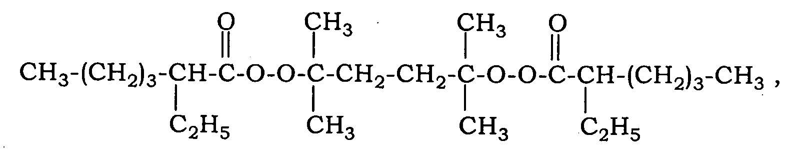 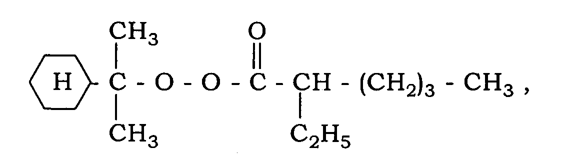 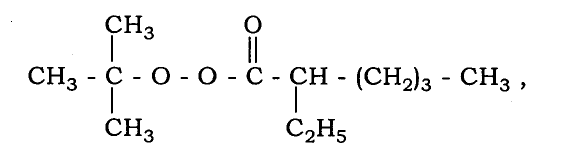 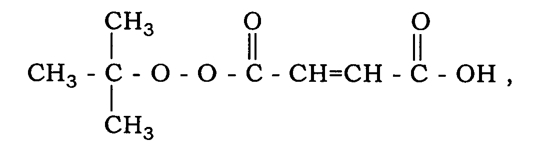 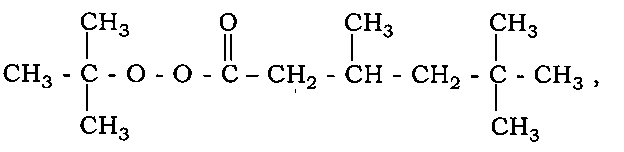 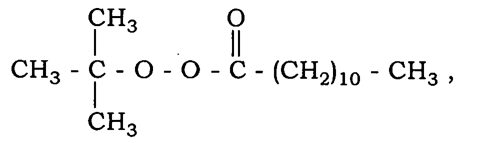 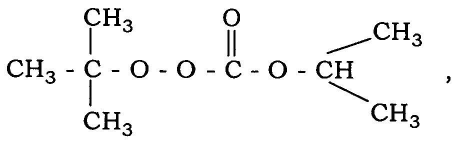 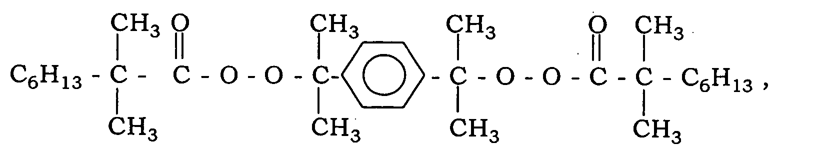 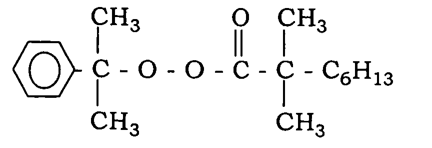 and the like.

Another preferred examples of the second kind of organic peroxide of the formula (1) are diacyl peroxides (p1=p2=1 in the formula (1)) which are preferred since transparency of the obtained polymer in a vacuum ultraviolet region can be improved more.

In the diacyl peroxides, preferred examples of R⁵⁰ and R⁵¹ are the same as R⁵⁰ and R⁵¹ in the above-mentioned organic peroxides.

Preferred examples of the diacyl peroxide are as follows: 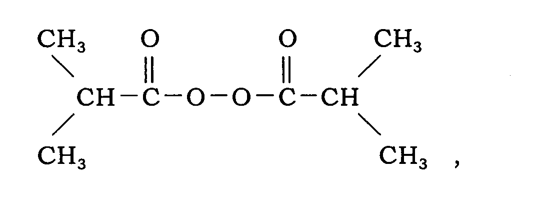 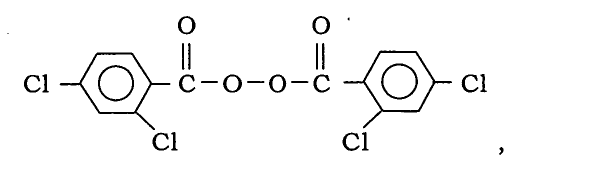 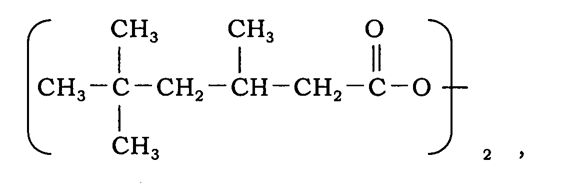 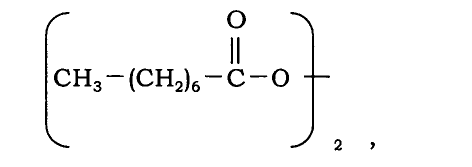 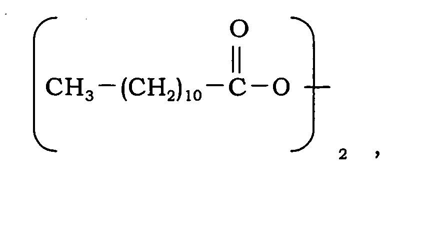 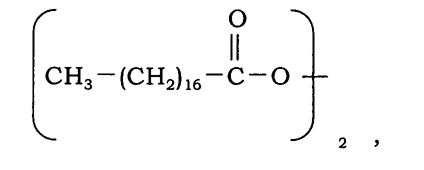 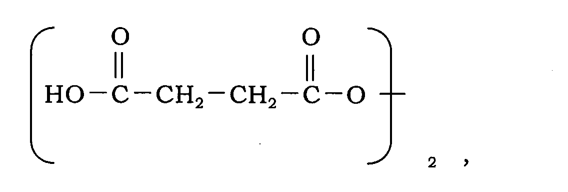 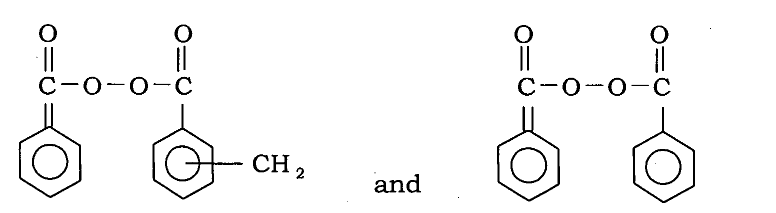 and also peroxy ketals (p1=p2=1, p3=2) are usable and can further improve transparency of the polymer in a vacuum ultraviolet region.

Examples of the peroxy ketals (p1=p2=1, p3=2) are: 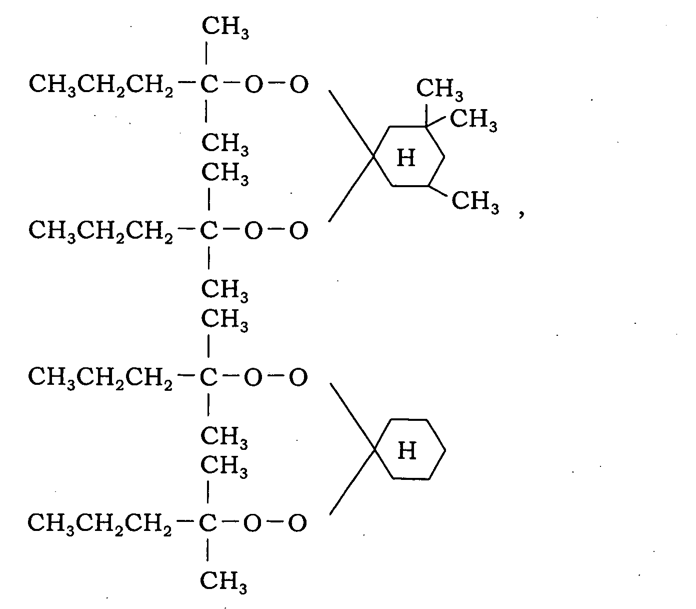 and the like.

In the present invention, when preparing the polymer having the structural unit derived from the fluorine-containing ethylenic monomer (m2), it is preferable to use, among the second kind of organic peroxides of the formula (1), those having a ten-hour half-life temperature of from 5° to 130°C, more preferably from 15° to 100°C, particularly preferably from 30° to 80°C, from the viewpoint of good polymerization reactivity.

Next, each monomer which is subjected to radical polymerization using the mentioned first and second kinds of organic peroxides is explained below.

Preferred examples of the monomer (m1) which is used for the first preparation process of the present invention are the same as those of the monomer (m3) in the second and third preparation processes, and the comonomer (n1) may be the monomer (m2) and/or the comonomer (n2) in the second and third preparation processes.

Therefore firstly each monomer component of the second and third fluorine-containing copolymers, namely fluorine-containing polymers to be used for resist application which are prepared according to the present invention, namely, the monomer (m3) being capable of providing an aliphatic ring structure, the fluorine-containing ethylenic monomer (m2) and the optional comonomer (n2) and further the acid-reactive group Y¹ reacting with an acid or the group Y² convertible to the acid-reactive group Y¹ in the polymer are explained, and lastly the monomer (m1) excluding the monomer (m3) which can be used in the first preparation process is referred to. The following explanation is made according to the second preparation process, but is common to the third preparation process.

First, the monomer (m3) which can provide the structural unit (M3) having an aliphatic ring structure in the polymer trunk chain and may have fluorine atom is explained below.

The monomer (m3) can introduce, to the polymer trunk chain, the structural unit (M3) which has an aliphatic ring structure and enhances dry etching resistance when the polymer is used for resist application. In combination of this effect with the mentioned effect of improving transparency in a vacuum ultraviolet region, the fluorine-containing polymer which has an aliphatic ring structure in its trunk chain and is prepared by the process of the present invention is preferred particularly for resist application using F2 laser.

The monomer (m3) may be selected from unsaturated cyclic compounds having a radically polymerizable carbon-carbon unsaturated bond in its ring structure or non-conjugated diene compounds which can form a ring structure in the trunk chain by cyclic polymerization of a diene compound.

Also, the monomer (m3) may contain or may not contain the acid-reactive functional group Y.

By (co)polymerizing this monomer (m3), a polymer having an aliphatic ring structural unit of monocyclic structure or polycyclic structure in its trunk chain can be obtained.

The first preferred monomer (m3) is a monocyclic monomer (m3-1) which has a radically polymerizable carbon-carbon unsaturated bond in its ring structure and does not have the acid-reactive functional group Y. Preferred is an aliphatic unsaturated hydrocarbon compound of 3-membered to 8-membered ring structure which may have ether bond in the ring structure.

Preferred examples of the monomer (m3-1) are concretely: 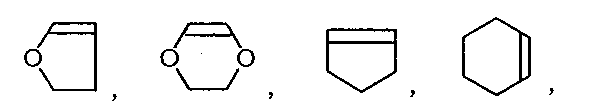 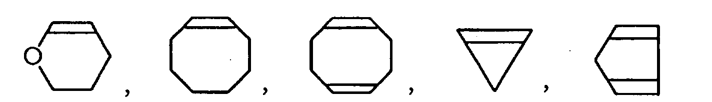 and the like.

Further in those monomers (m3-1), a part or the whole of hydrogen atoms may be substituted with fluorine atoms, and there are preferably: 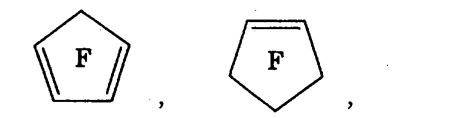 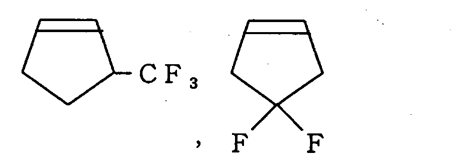 and the like.

The second preferred monomer (m3) is a monomer (m3-2) which is a monocyclic aliphatic unsaturated hydrocarbon compound having the acid-reactive functional group Y. Preferred is an unsaturated hydrocarbon compound of 3-membered to 8-membered ring structure which may have ether bond in the ring structure. Also a part or the whole of hydrogen atoms of the monomer (m3-2) may be substituted with fluorine atoms in the same manner as in (m3-1) mentioned above.

Examples of the monocyclic monomer (m3-2) having the acid-reactive functional group Y are: 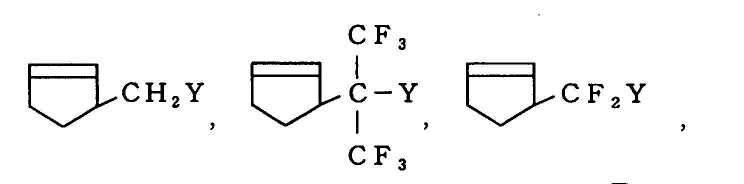 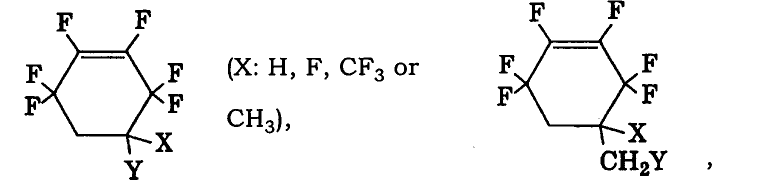 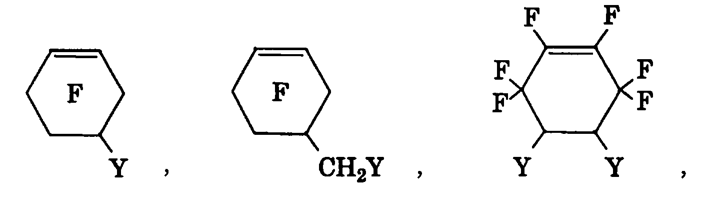 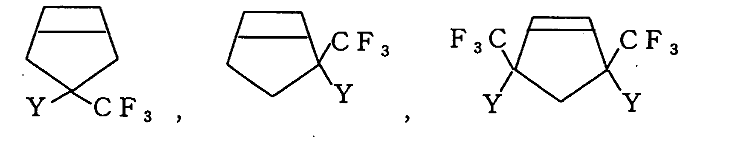 and the like.

The third preferred monomer (m3) is a monomer (m3-3) which introduces, to the polymer trunk chain, a structural unit having an aliphatic polycyclic structure not having the acid-reactive functional group Y. The preferred monomer (m3-3) is a norbornene derivative.

Examples of the monomer (m3-3) having an aliphatic polycyclic structure which does not have the acid-reactive functional group Y are concretely: 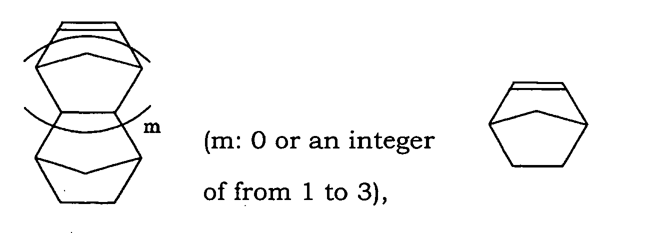 and the like.

The above-exemplified norbornenes may have fluorine atom introduced to the ring structure thereof. The introduction of fluorine atom can enhance transparency without lowering dry etching resistance.

Concretely there are fluorine-containing norbornenes represented by the formula: 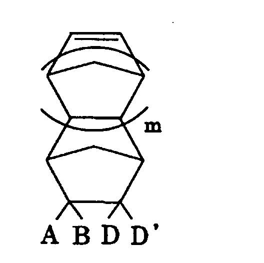 wherein A, B, D and D' are the same or different and each is H, F, an alkyl group having 1 to 10 carbon atoms or a fluorine-containing alkyl group having 1 to 10 carbon atoms; m: 0 or an integer of from 1 to 3; any one of A, B, D and D' contains fluorine atom. Examples thereof are fluorine-containing norbornenes represented by: 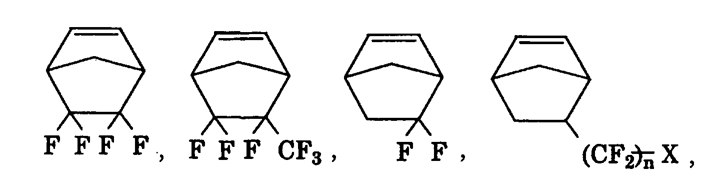 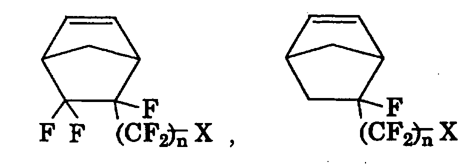 (n: 1 to 10, X:H, F or Cl)
and the like.

Other examples thereof are norbornene derivatives represented by: 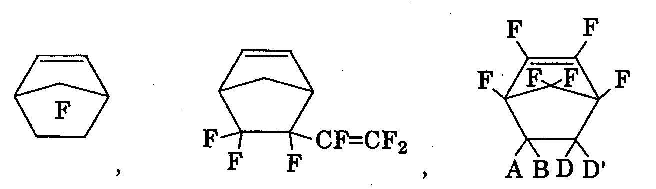 (A, B, D and D' are H, F, alkyl groups or fluorine-containing alkyl groups having 1 to 10 carbon atoms)
and the like.

The fourth preferred monomer (m3) is a monomer (m3-4) which introduces, to the polymer trunk chain, an aliphatic polycyclic structure having the acid-reactive functional group Y. The preferred monomer (m3-4) is a norbornene derivative.

Examples of the monomer (m3-4) which has an aliphatic polycyclic structure having the acid-reactive functional group Y are: 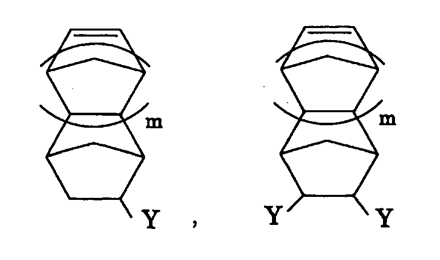 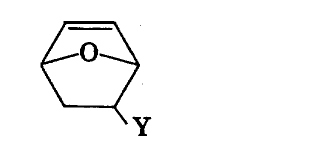 (m: 0 or an integer of from 1 to 3),
and the like.

Further the monomer (m3-4) which has an aliphatic polycyclic structure having the acid-reactive functional group Y may be a monomer, in which a part or the whole of hydrogen atoms bonded to the ring structure are substituted with fluorine atoms. This monomer is preferred since transparency can be imparted more to the polymer.

Examples thereof are fluorine-containing norbornene derivatives represented by: 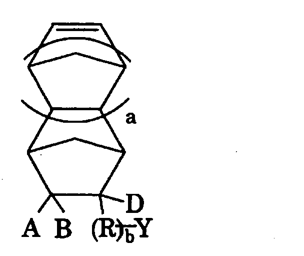 wherein A, B and D are the same or different and each is H, F, an alkyl group having 1 to 10 carbon atoms or a fluorine-containing alkyl group having 1 to 10 carbon atoms which may have ether bond; R is a divalent hydrocarbon group having 1 to 20 carbon atoms, a fluorine-containing alkylene group having 1 to 20 carbon atoms or a fluorine-containing alkylene group having 2 to 100 carbon atoms and ether bond; a is 0 or an integer of from 1 to 5; b is 0 or 1; when b is 0 or R does not have fluorine atom, any one of A, B and D is a fluorine atom or a fluorine-containing alkyl group which may have ether bond.

It is preferable that any of A, B or D is a fluorine atom or when fluorine atom is not contained in A, B and D, a fluorine content of R is not less than 60 % by weight, and it is further preferable that R is a perfluoroalkylene group since transparency can be imparted to the polymer.

As a method of measuring a fluorine content, generally there is used a method of calculating the fluorine content by analyzing a polymer composition from measurements with ¹⁹F-NMR and ¹H-NMR using equipment and measuring conditions mentioned infra. When it is difficult to analyze a polymer structure by the above-mentioned method, there is used a method of elementary analysis of fluorine, in which 2 mg of a sample and a combustion improver (10 mg of sodium peroxide) are wrapped with a filter paper (filter paper No. 7 available from Toyo Roshi) and are put in a platinum basket and then are burned in a 500 ml flask filled with 25 ml of pure water. Immediately after the burning, the flask is shaken to absorb fluorine ion in pure water and then fluorine ion absorbed in pure water is analyzed with a fluorine ion electrode.

Examples of the norbornene derivatives are those represented by: 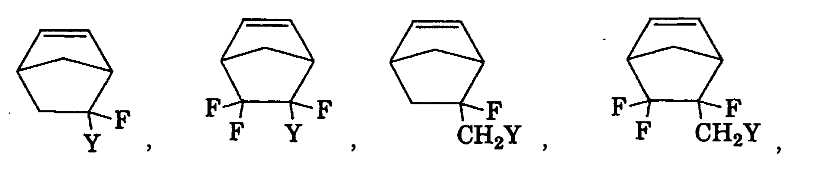 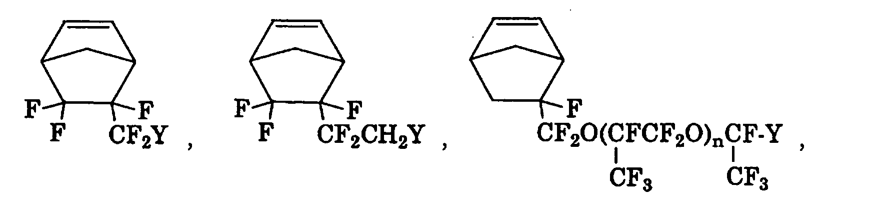 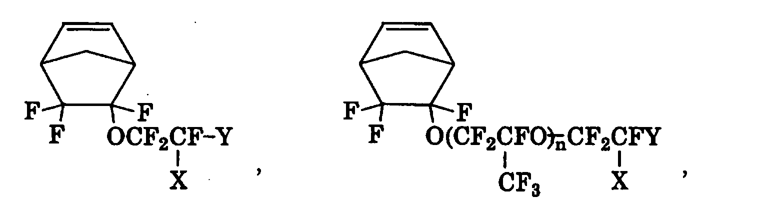 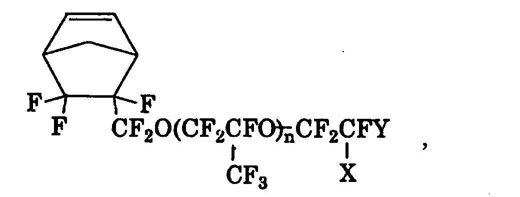 (n: 0 to 10, X: F or CF₃) 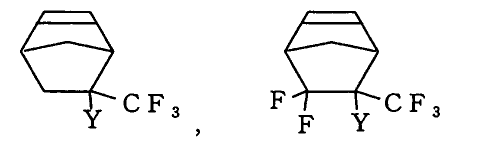 and the like.

Further there are fluorine-containing norbornene derivatives represented by: 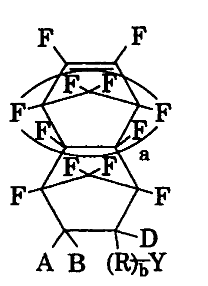 wherein A, B and D are the same or different and each is H, F, an alkyl group having 1 to 10 carbon atoms or a fluorine-containing alkyl group having 1 to 10 carbon atoms which may have ether bond; R is a divalent hydrocarbon group having 1 to 20 carbon atoms, a fluorine-containing alkylene group having 1 to 20 carbon atoms or a fluorine-containing alkylene group having 2 to 100 carbon atoms and ether bond; a is 0 or an integer of from 1 to 5; b is 0 or 1.

Concretely there are preferably norbornene derivatives represented by: 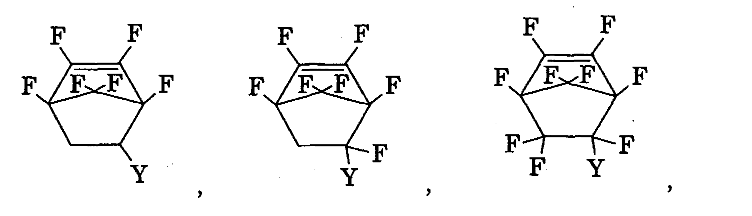 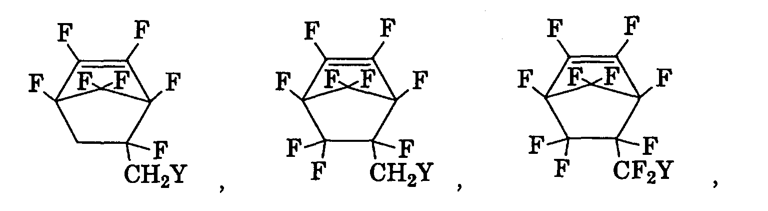 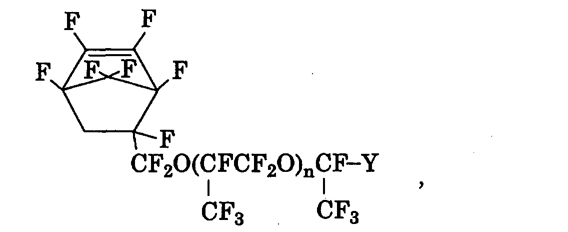 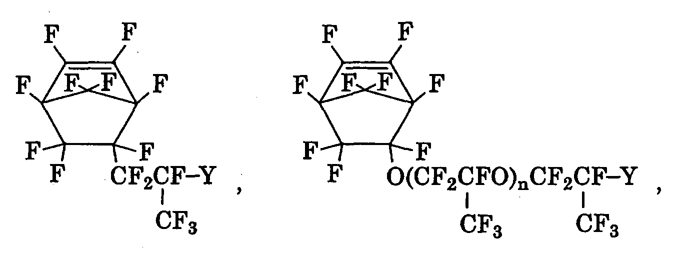 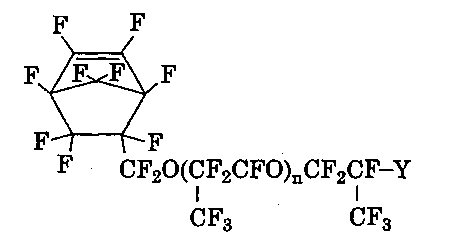 (X: F or CF₃, n: 0 to 10) and the like.

Further preferred examples of the monomer (m3-4) which has an aliphatic polycyclic structure having the acid-reactive functional group Y are fluorine-containing norbornene derivatives represented by: 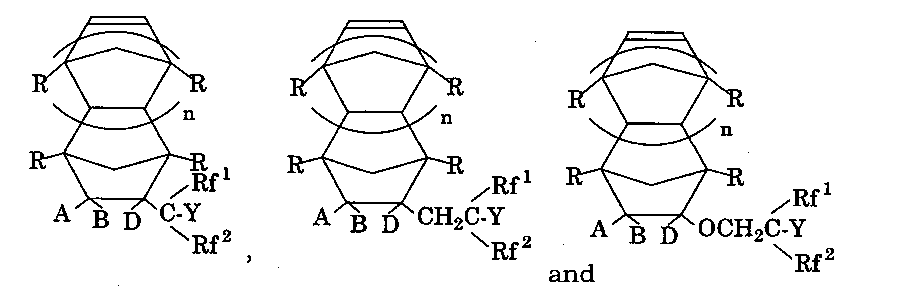 wherein Rf¹ and Rf² are the same or different and each is a fluorine-containing alkyl group or fluorine-containing alkyl group having ether bond which has 1 to 10 carbon atoms; A, B and D are the same or different and each is H, F, Cl, an alkyl group having 1 to 10 carbon atoms or a fluorine-containing alkyl group having 1 to 10 carbon atoms which may have ether bond; R is H or an alkyl group having 1 to 10 carbon atoms; n is 0 or an integer of from 1 to 5.

Examples thereof are, for instance: 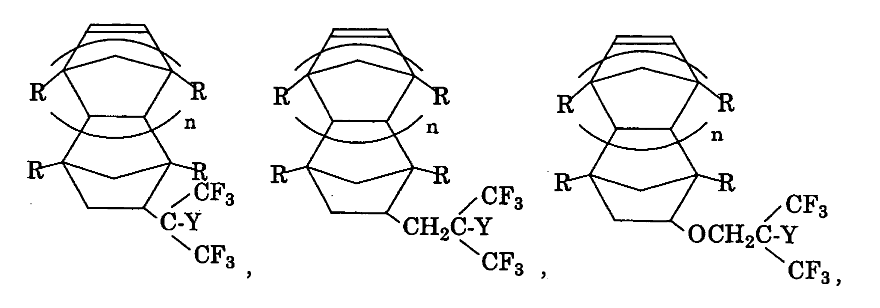 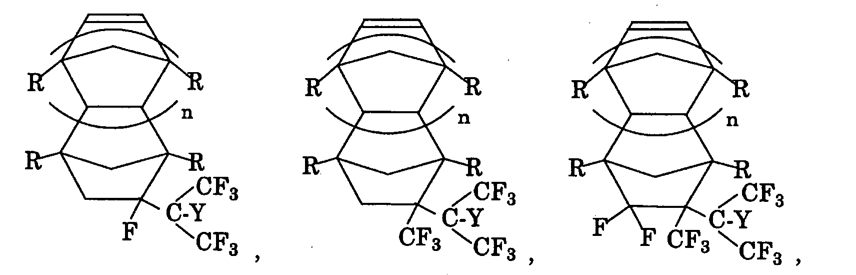 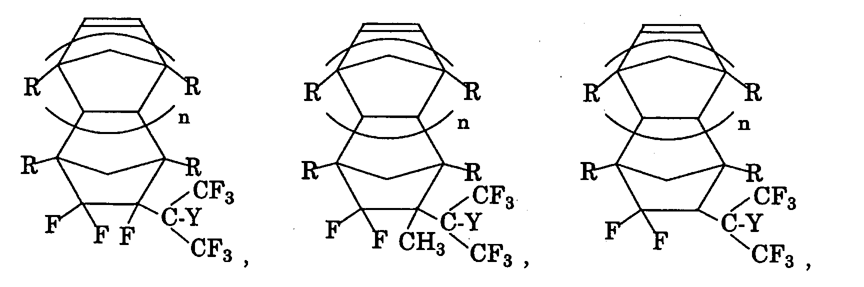 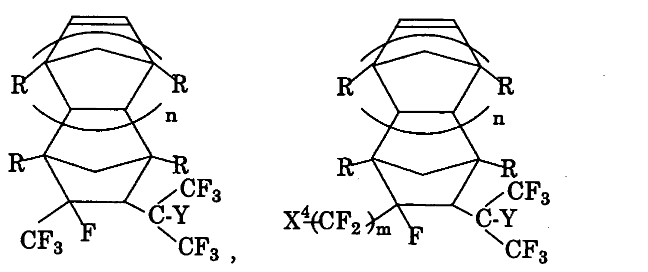 (R and n are as defined above, X⁴: H, F or Cl,
m: from 1 to 10)
and the like.

Particularly there are preferably: 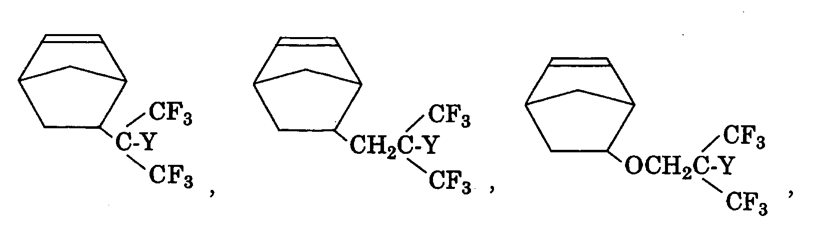 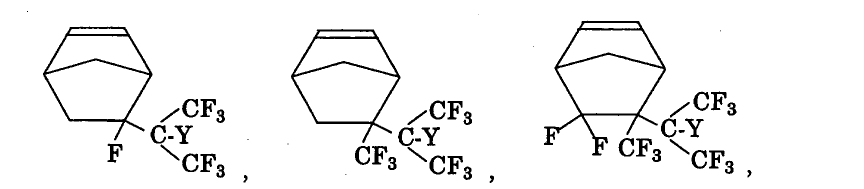 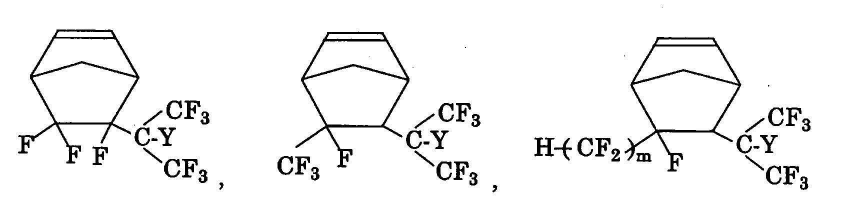 (m: from 1 to 10)
and the like.

Other examples are norbornene derivatives represented by the formula: 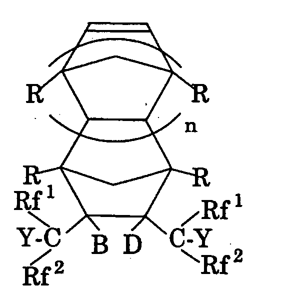 wherein Rf¹ and Rf² are the same or different and each is a fluorine-containing alkyl group or fluorine-containing alkyl group having ether bond which has 1 to 10 carbon atoms; B and D are the same or different and each is H, F, Cl, an alkyl group having 1 to 10 carbon atoms or a fluorine-containing alkyl group having 1 to 10 carbon atoms which may have ether bond; R is H or an alkyl group having 1 to 10 carbon atoms; n is 0 or an integer of from 1 to 5.

Those exemplified monomers (m3-3) and (m3-4) having an aliphatic polycyclic structure are preferred particularly as materials for resist polymer since dry etching resistance can be imparted to the polymer, and also are preferred since the polymer can be prepared efficiently by radical polymerization method according to the preparation process of the present invention and transparency can be effectively improved. Particularly norbornene derivatives having fluorine atom in its polycyclic structure are preferred from the viewpoint of transparency and are also preferred since the polymer can be prepared efficiently by radical polymerization method according to the preparation process of the present invention and transparency can be effectively improved.

Also the norbornene derivatives (m3-4) having the acid-reactive functional group Y are preferred since a functional group necessary for resist application can be efficiently introduced to the polymer, which, as a result, is advantageous from the viewpoint of transparency and dry etching resistance.

The fifth preferred monomer (m3) is a non-conjugated diene compound (m3-5) which can form an aliphatic ring structure by polymerization and may have fluorine atom. The non-conjugated diene compound (m3-5) can efficiently provide a polymer having a structural unit of ring structure in its trunk chain and can improve transparency in a vacuum ultraviolet region like the monomers as mentioned above.

Preferred examples of the non-conjugated diene compound (m3-5) are, for instance, specific divinyl compounds introducing a monocyclic structure to the trunk chain by cyclic polymerization.

Examples thereof are, for instance, diallyl compounds which may have fluorine atom and the acid-reactive functional group Y and are represented by the formula: 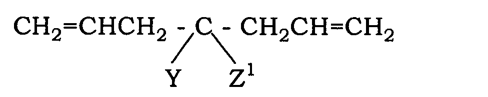 and 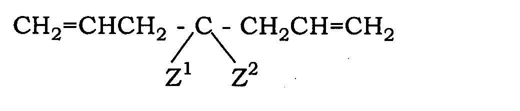 wherein Z¹ and Z² are the same or different and each is hydrogen atom, fluorine atom, a hydrocarbon group having 1 to 5 carbon atoms which may have ether bond or a fluorine-containing alkyl group having 1 to 5 carbon atoms which may have ether bond.

By radical cyclic polymerization of this diallyl compound, a monocyclic structural unit represented by: 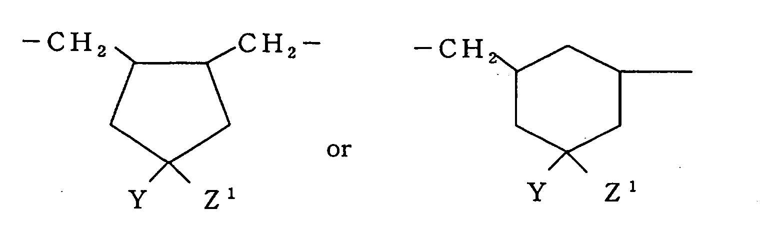 or 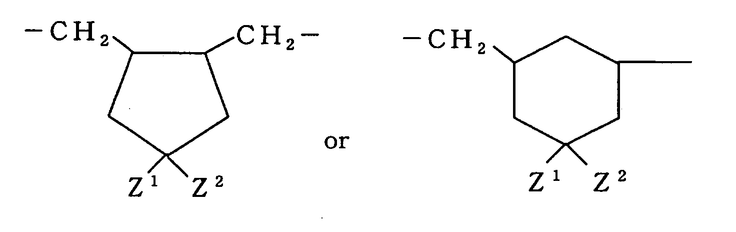 wherein Z¹ and Z² are as defined above, can be formed in the trunk chain.

In the above-mentioned radical cyclic polymerization, too, fluorine-containing polymers having a ring structure can be efficiently prepared when the first kind of organic peroxide having a structural unit of the formula (1-1) or (1-2) or the second kind of organic peroxide of the formula (1) of the present invention is used, and transparency in a vacuum ultraviolet region can be improved as mentioned above.

The acid-reactive functional group Y is then explained below. The acid-reactive functional group Y is a generic term of the acid-reactive group Y¹ and the group Y² convertible to the acid-reactive group Y¹ as mentioned above.

In the present invention, the acid-reactive group Y¹ means an acid-labile or acid-decomposable functional group and an acid-condensing functional group.
(i) Acid-labile or acid-decomposable functional group

The acid-labile or acid-decomposable functional group is a functional group which can make the polymer soluble in alkali due to function of an acid though the polymer is insoluble or hardly soluble in alkali before reaction with an acid. The polymer can be used as a base polymer for a positive resist because of this change of solubility in alkali.

The functional group has an ability of changing to -OH group, -COOH group, -SO₃H group and the like due to action of an acid or a cation and as a result, the fluorine-containing polymer becomes soluble in alkali.

Examples of the acid-labile or acid-decomposable functional group which can be used preferably are: 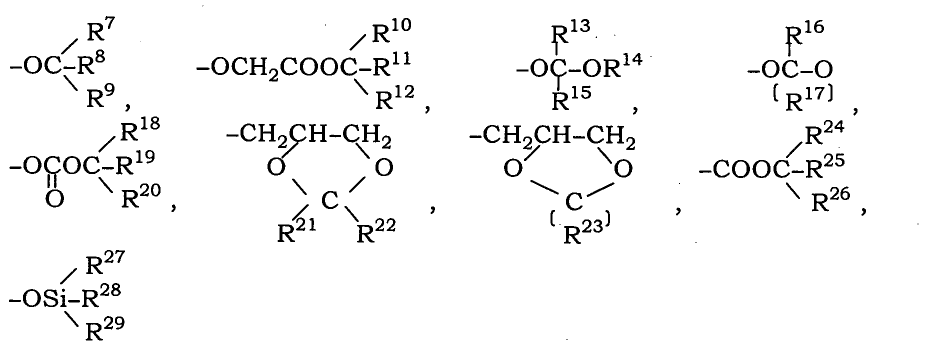 and the like,
wherein R⁷, R⁸, R⁹,R¹⁰, R¹¹, R¹², R¹⁴,R¹⁸, R¹⁹, R²⁰, R²¹, R²², R²⁴, R²⁵, R²⁶, R²⁷, R²⁸ and R²⁹ are the same or different and each is a hydrocarbon group having 1 to 10 carbon atoms; R¹³, R¹⁵ and R¹⁶ are the same or different and each is H or a hydrocarbon group having 1 to 10 carbon atoms; and R¹⁷ and R²³ are the same or different and each is a divalent hydrocarbon group having 2 to 10 carbon atoms.

More concretely there are preferably:
-OCH₂OCH₃ , -OCH₂OC₂H₅ , -OC(CH₃)₃ , -OCH₂COOC(CH₃)₃ , 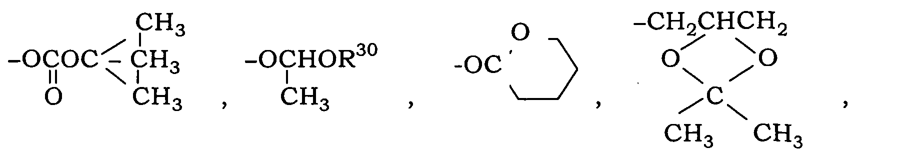 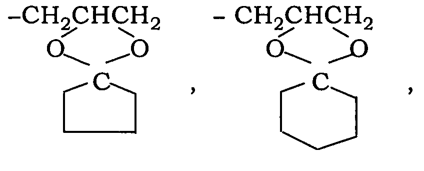 -COOC(CH₃)₃ , -OSi(CH₃)₃
and the like, wherein R³⁰ is an alkyl group having 1 to 10 carbon atoms.

### (ii) Functional group undergoing acid-condensing reaction

The functional group undergoing acid-condensing reaction is a functional group which can make the polymer insoluble in an alkaline developing solution (or other developing solvent) due to action of an acid though the polymer is soluble in an alkaline developing solution (or other developing solvent) before reaction with an acid.

The functional group undergoing acid-condensation reaction is concretely a functional group which causes self-condensation or poly-condensation due to action of an acid or cation or condensation reaction or poly-condensation reaction with a crosslinking agent due to action of an acid in the presence of the crosslinking agent, or a functional group which causes a change in polarity by rearrangement by an acid or cation (for example, pinacol rearrangement or carbinol rearrangement). As a result, in any of the above-mentioned cases, the polymer becomes insoluble in an alkaline developing solution (or other developing solvent).

By making the polymer insoluble in a developing solution, the polymer can be used as a base polymer for a negative type resist.

Preferred examples of the functional group undergoing condensation reaction by an acid are those selected from -OH, -COOH, -CN, -SO₃H, epoxy group and the like.

The crosslinking agent is not limited particularly when used and can be optionally selected from crosslinking agents which have been usually used for negative resists. Preferred examples of crosslinking agent are, for instance, N-methylol melamine, N-alkoxymethylated melamine compounds, urea compounds, epoxy compounds, isocyanate compounds and the like.

Among the above-mentioned acid-reactive groups Y¹, preferred is at least one of OH group, an acid-labile functional group which can be converted to OH group by an acid, COOH group and an acid-labile functional group which can be converted to COOH group by dissociation with an acid.

Examples of the acid-labile functional group which can be converted to OH group by an acid are groups represented by: 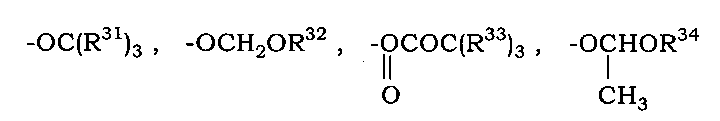 and 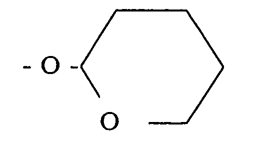 wherein R³¹, R³², R³³ and R³⁴ are the same or different and each is an alkyl group having 1 to 5 carbon atoms.

More concretely there are:
-OC(CH₃)₃ , -OCH₂OCH₃, -OCH₂OC₂H₅ , 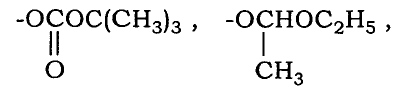 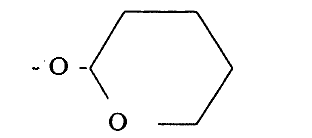 and the like. Particularly preferred are: 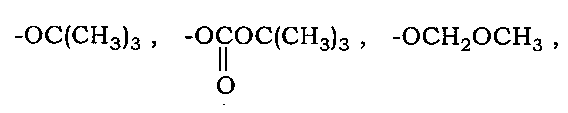 and -OCH₂OC₂H₅
because of good acid reactivity, and -OC(CH₃)₃, -OCH₂OCH₃ and -OCH₂OC₂H₅ are preferred because of good transparency.

Examples of the acid-labile functional group which can be converted to -COOH group by an acid are: 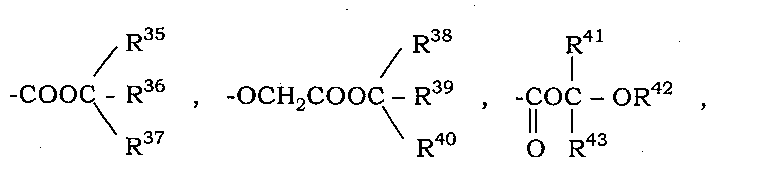 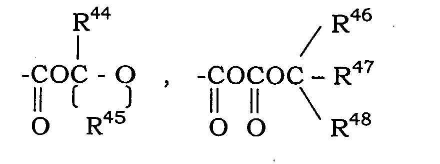 and the like, wherein R³⁵, R³⁶, R³⁷, R³⁸, R³⁹, R⁴⁰, R⁴¹, R⁴², R⁴⁶, R⁴⁷ and R⁴⁸ are the same or different and each is a hydrocarbon group having 1 to 10 carbon atoms; R⁴³ and R⁴⁴ are the same or different and each is H or a hydrocarbon group having 1 to 10 carbon atoms; R⁴⁵ is a divalent hydrocarbon group having 2 to 10 carbon atoms, and particularly preferred are:
-COOC(CH₃)₃ , -OCH₂COOC(CH₃)₃ , 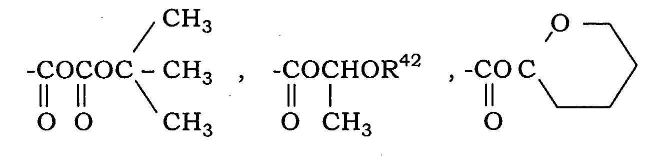 and the like, wherein R⁴² is as defined above.

Usually those acid-reactive functional groups Y¹ can be introduced to the polymer by polymerizing a monomer having the acid-reactive functional group Y¹ according to the preparation process of the present invention.

Or the polymer having the acid-reactive group Y¹ can be obtained by introducing the acid-reactive group Y¹ to the polymer by polymerizing a monomer having the group Y² convertible to the acid-reactive group Y¹ according to the preparation process of the present invention and then converting the group Y² to the acid-reactive group Y¹ through polymer reaction.

Example of a method of introducing the intended acid-reactive group Y¹ through polymer reaction is, for instance, a method of preparing a fluorine-containing polymer having the group Y² convertible to the acid-reactive group Y¹ by copolymerizing, with ml and/or m2, a vinyl ester compound (a monomer having the group Y² (ester group) convertible to the acid-reactive group) represented by the formula: 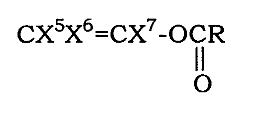 wherein X⁵ and X⁶ are H or F; X⁷ is H, CH₃ or CF₃; R is an alkyl group or fluorine-containing alkyl group which has 1 to 5 carbon atoms, according to the preparation process of the present invention, and then hydrolyzing the group Y² convertible to the acid-reactive group of the obtained fluorine-containing polymer with alkali, thereby converting to OH group (acid-reactive group Y¹).

The present invention encompasses a method of preparing the fluorine-containing polymer having the acid-reactive group Y¹ through the process of polymer reaction.

In any of the above cases, according to the preparation process of the present invention, the fluorine-containing polymer having the acid-reactive group Y¹ can be obtained efficiently, and also transparency in a vacuum ultraviolet region and developing characteristics can be improved.

The fluorine-containing polymer having the acid-reactive functional group Y can be obtained by carrying out radical polymerization of at least one of the monomers having the acid-reactive functional group Y among the above-mentioned monomers (m2), the monomers having the acid-reactive functional group Y among the monomers (m3-2) or (m3-4) being capable of giving an aliphatic ring structure and the divinyl compounds (m3-5) having the acid-reactive functional group Y and being capable of cyclic polymerization, by using a specific polymerization initiator.

When monomers having no acid-reactive functional group Y are used as the monomers (m2) and (m3), a monomer (n2-1) having the acid-reactive functional group Y among the comonomers (n2) may be copolymerized in addition to the monomers (m2) and (m3) to introduce the third structural unit (N2-1) having the acid-reactive functional group Y in addition to the structural units (M2) and/or (M3).

Examples of the preferred monomer (n2-1) which can introduce the acid-reactive functional group Y to the optional structural unit (N2-1) are copolymerizable ethylenic monomers having the acid-reactive functional group Y.

Preferred examples thereof are acrylic monomers having the acid-reactive functional group Y, fluorine-containing acrylic monomers having the acid-reactive functional group Y, allyl ether monomers having the acid-reactive functional group Y, fluorine-containing allyl ether monomers having the acid-reactive functional group Y, vinyl ether monomers having the acid-reactive functional group Y, fluorine-containing vinyl ether monomers having the acid-reactive functional group Y and the like.

Examples thereof are (meth)acrylic acid, α-fluoroacrylic acid, α-trifluoromethyl acrylic acid, t-butyl (meth)acrylate, t-butyl-α-fluoroacrylate, t-butyl-α-trifluoromethyl acrylate, CH₂=CHCH₂Y, CH₂=CHCH₂OCH₂CH₂Y, 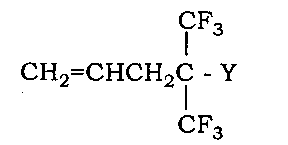 and fluorine-containing ethylenic monomers represented by the formula: 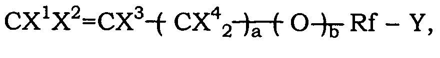 wherein X¹ and X² are the same or different and each is H or F; X³ is H, F, CH₃ or CF₃; X⁴ is H, F or CF₃; Rf is a fluorine-containing alkylene group having 1 to 40 carbon atoms or a fluorine-containing alkylene group having 2 to 100 carbon atoms and ether bond; a is 0 or an integer of from 1 to 3; b is 0 or 1.

Among them, fluorine-containing allyl ether compounds represented by CH₂=CF-CF₂O-Rf-Y, wherein Rf is as defined above, are preferred.

More concretely there are preferably fluorine-containing allyl ether compounds represented by:

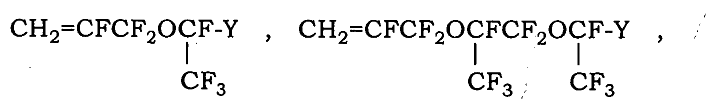

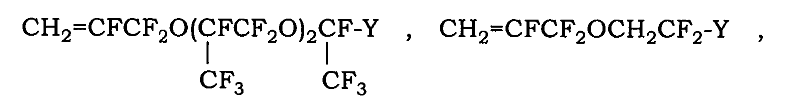

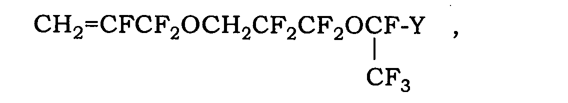

CH₂=CFCF₂OCF₂CF₂OCF₂-Y , CH₂=CFCF₂O(CF₂CF₂O)₂CF₂-Y

and the like.

Also fluorine-containing vinyl ether compounds represented by the formula: CF₂=CF-O-Rf-Y, wherein Rf is as defined above, are preferred.

More concretely there are preferably fluorine-containing vinyl ether compounds represented by: 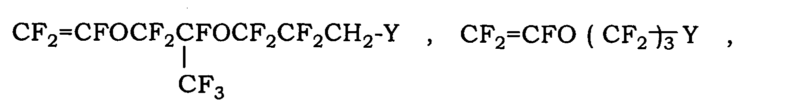 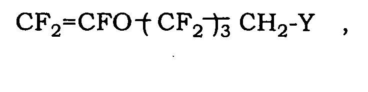 CF₂=CFOCF₂CF₂OCF₂-Y ,
CF₂=CFOCF₂CF₂OCF₂CH₂-Y , CF₂=CFOCF₂CF₂CH₂OC F₂CF₂-Y ,
CF₂=CFOCF₂CF₂CH₂OCF₂CF₂CH₂-Y, 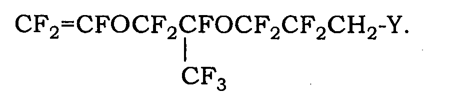 and the like.

Examples of other fluorine-containing ethylenic monomers having the acid-reactive functional group Y are:
CF₂=CF-CF₂O-Rf-Y , CF₂=CF-Rf-Y ,
CH₂=CH-Rf-Y , CH₂=CH-O-Rf-Y
and the like, wherein Rf is as defined above, and more concretely there are:
CF₂=CFCF₂OCF₂CF₂CF₂-Y , CF₂=CFCF₂OCF₂CF₂CF₂CH₂-Y , 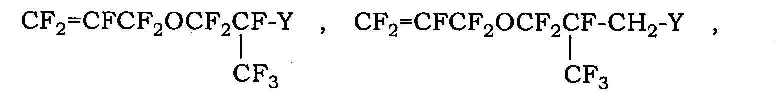 CF₂=CFCF₂-Y- , CF₂=CFCF₂CH₂-Y ,
CH₂=CHCF₂CF₂CH₂CH₂-Y , CH₂=CHCF₂CF₂-Y ,
CH₂=CHCF₂CF₂CH₂-Y , CH₂=CHCF₂CF₂CF₂CF₂-Y ,
CH₂=CHCF₂CF₂CF₂CF₂CH₂-Y , CH₂=CHO-CH₂CF₂CF₂-Y ,
CH₂=CHOCH₂CF₂CF₂CH₂-Y
and the like.

Next, the monomer (m2) introducing the structural unit (M2) to the second fluorine-containing polymer is a fluorine-containing ethylenic monomer which has two or three carbon atoms, one polymerizable, particularly radically polymerizable carbon-carbon double bond and at least one fluorine atom.

Such a fluorine-containing ethylenic monomer (m2) is a mono-ene compound having one polymerizable carbon-carbon double bond and does not form a structural unit having a ring structure in a trunk chain even by polymerization.

The fluorine-containing ethylenic monomer (m2) may have or may not have the acid-reactive functional group Y, and it is usually preferable to use a monomer having no acid-reactive functional group because reactivity of radical polymerization is good and also because transparency can be improved more effectively.

Preferred as the fluorine-containing ethylenic monomer (m2) is ethylene or propylene, in which at least one of hydrogen atoms is substituted with fluorine atom. Other hydrogen atoms may be substituted with halogen atoms other than fluorine atom.

Particularly preferred are monomers, in which at least one fluorine atom is bonded to the carbon atom forming the carbon-carbon double bond, thereby making it possible to introduce fluorine atom to the structural unit (M2), namely to the polymer trunk chain and obtain a fluorine-containing polymer providing excellent transparency particularly in a vacuum ultraviolet region.

Concretely preferred example thereof is at least one monomer selected from tetrafluoroethylene, chlorotrifluoroethylene, vinylidene fluoride, vinyl fluoride, trifluoroethylene, hexafluoropropylene and CH₂=CFCF₃.

Among them, preferred are at least one of tetrafluoroethylene, chlorotrifluoroethylene, vinylidene fluoride and hexafluoropropylene and a mixture of two or more thereof from the viewpoint of transparency. Particularly preferred are tetrafluoroethylene and/or chlorotrifluoroethylene.

In the second preparation process of the present invention, a radically polymerizable monomer may be copolymerized as an optional comonomer (n2) to improve other properties of the obtained second fluorine-containing copolymer, for example, mechanical strength and coatability.

Such an optional monomer (n2) is selected from the above-mentioned comonomers (n2-1) and in addition, monomers being copolymerizable with monomers (m2) and (m3) for other structural units (M2) and (M3).

For example, there are monomers mentioned below.

### Acrylic monomers (excluding monomers raised in n2-1):

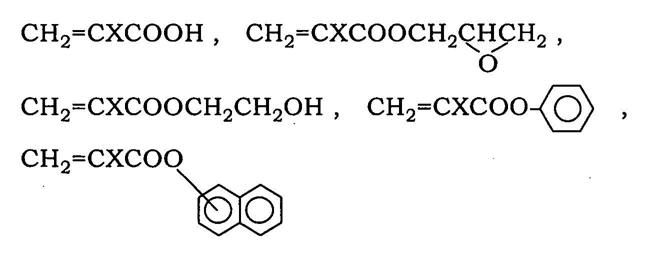

and 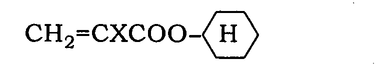 (X is selected from H, CH₃, F and CF₃).

### Styrene monomers:

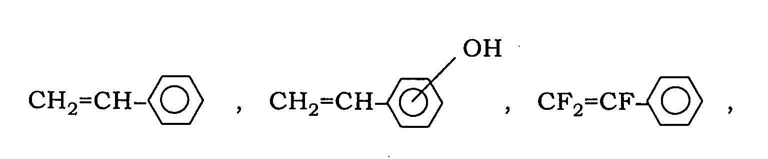

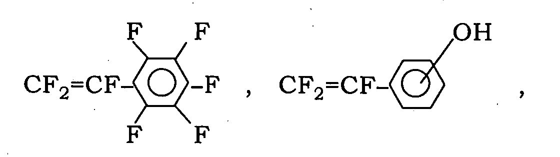

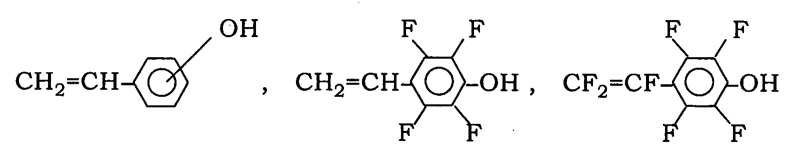

and 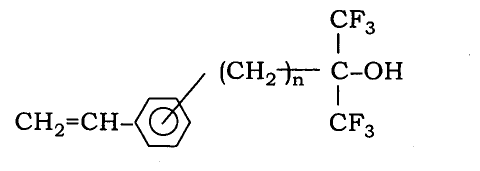 wherein n is 0 or an integer of 1 or 2.

Ethylenic monomers:
CH₂=CH₂, CH₂=CHCH₃, CH₂=CHCl and the like.

Maleic acid monomers: 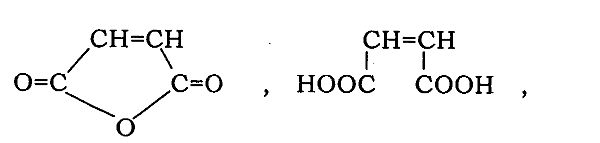 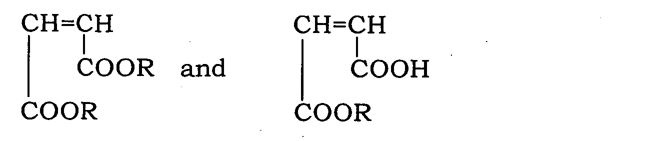 wherein R is a hydrocarbon group having 1 to 20 carbon atoms.

Allyl monomers:
CH₂=CHCH₂Cl , CH₂=CHCH₂OH , CH₂=CHCH₂COOH ,
CH₂=CHCH₂Br and the like.

Allyl ether monomers:
CH₂=CHCH₂OR (R is a hydrocarbon group having 1 to 20 carbon atoms), 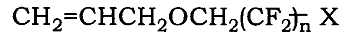 (n: from 1 to 10, X: H, C1 or F),
CH₂=CHCH₂OCH₂CH₂COOH ,

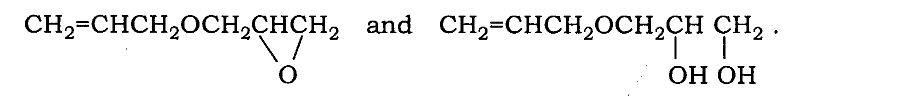

Examples of other monomer are: 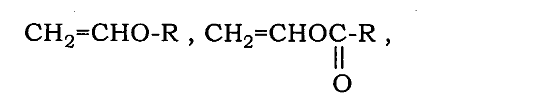 (R is an alkyl group which has 1 to 20 carbon atoms and may be substituted with fluorine)

More concretely there are: 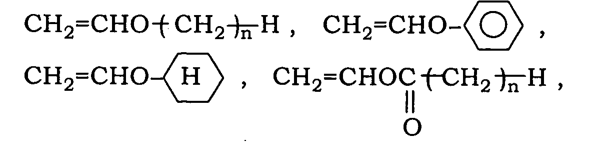 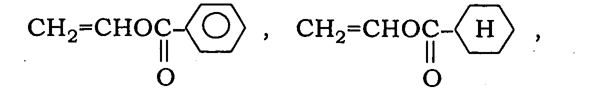 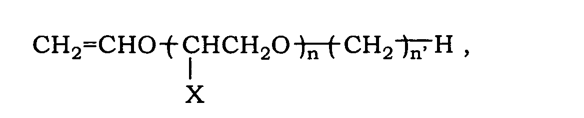 (n: from 1 to 20, n': from 0 to 5, X: H or CH₃)
and the like.

The monomers used for the second preparation process are explained above and as mentioned above, the explanation is common to the third preparation process, and further the monomer (m1) used in the first preparation process can be the monomer (m3) and the comonomer (n1) can be the monomer (m2) and/or the comonomer (n2) used in the second preparation process.

When a fluorine-containing polymer for other applications than the photoresist polymer application is prepared, the intended first fluorine-containing polymer may have or may not have the acid-reactive functional group Y.

Therefore the monomer (m1) may be the monomer (m3) and other monomers, for example:
CF₂=CFCF₂CF₂CF=CF₂ , CF₂=CFCF₂OCF=CF₂ ,
CH₂=CFCF₂OCF=CF₂ , CF₂=CFOCF₂OCF=CF₂ ,
CF₂=CFOCF₂CF₂OCF=CF₂ , 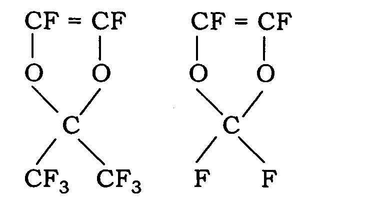 and the like, and examples of the comonomer (n1) are:
CF₂=CF-(CF₂)ₙ-X¹⁰, CH₂=CF-(CF₂)ₙ-X¹⁰ , CH₂=CH-(CF₂)ₙ-X¹⁰
and the like, wherein X¹⁰ is selected from H, F and C1; n is an integer of from 2 to 10, in addition to the above-mentioned monomer (m2) and the comonomer (n2).

Among the above-exemplified monomers having the acid-reactive functional group Y, there may be used the monomers having a functional group Y¹⁰ instead of the acid-reactive functional group Y, in which Y¹⁰ is a moiety having a radically reactive carbon-carbon double bond (for example, acryloyl group, methacryloyl group, α-fluoroacryloyl group, vinyloxyl group or the like), a moiety having an aliphatic cyclic ether capable of ring opening by an acid (epoxy group, oxetanyl group or the like), a curable functional group such as cyano group or isocyanate group, a sulfonic acid fluoride group or the like.

The first fluorine-containing polymer, when having the acid-reactive functional group Y, is useful as a polymer for a photoresist composition like the second fluorine-containing polymer for a resist. When having no acid-reactive functional group Y, the first fluorine-containing polymer has a hydrophilic OH group at its end and therefore, is useful for applications such as a coating, a coating composition or a film requiring weather resistance for purposes of improvement of adhesion to a substrate and compatibility with a curing agent and additives and also for purposes of surface modification and improvement of dispersibility when used as an additive for heat resistant engineering plastics.

Also the first fluorine-containing polymer is useful for purposes and applications such as improvements of adhesion to a substrate, coatability and compatibility with additives such as curing agent and other monomers in the case of a coating composition for antireflection making use of a low refractive index of the polymer.

In the first preparation process of the present invention, the monomer (m1) being capable of introducing an aliphatic ring structure to the polymer trunk chain and as case demands, the comonomer (n1) are subjected to (co)polymerization through various known methods by using the organic peroxide having the structural unit of the formula (1-1) or (1-2).

In the second and third preparation processes of the present invention, the ethylenic monomer (m2) having two or three carbon atoms and at least one fluorine atom, or any of the monomers (m3-1) to (m3-5) being capable of introducing an aliphatic ring structure to the polymer trunk chain and as case demands, the comonomers including the ethylenic monomer (n2-1) having the acid-reactive functional group are subjected to (co)polymerization through various known methods by using the organic peroxides having the above-mentioned first or second kind of organic peroxide.

Explained below are concrete preferable polymerization conditions. Since there is no particular difference in polymerization conditions between the first preparation process and the second and third preparation processes except special conditions attributable to the monomers to be used, the explanation is made without discriminating among those preparation processes. When there is no necessity for discriminating between the first kind of organic peroxide and the second kind of organic peroxide, those kinds of peroxides are referred to simply as an organic peroxide.

For the polymerization, there can be used a method of solution polymerization in an organic solvent dissolving the monomers, a method of suspension polymerization in an aqueous medium in the presence or absence of a proper organic solvent, a method of emulsion polymerization by adding an emulsifying agent in an aqueous medium, a method of bulk polymerization without using a solvent and the like. Among them, solution polymerization and suspension polymerization using an organic solvent are preferred.

A solvent for the polymerization is not limited particularly. Examples of a solvent which can be used preferably are hydrocarbon solvents, fluorine-containing solvents (flon solvents), chlorine solvents, alcohol solvents, ketone solvents, acetic acid ester solvents, ether solvents and the like.

Among them, fluorine-containing solvents and chlorine solvents are preferred because solubility of the monomers and organic peroxide is good and also because the polymerization reaction can be advanced satisfactorily. Concretely preferred are one or two or more of solvents selected from hydrofluorocarbons, hydrochlorocarbons, fluorochlorocarbons and hydrochlorofluorocarbons.

The polymerization is initiated by bringing the mentioned organic peroxide contact with the monomers and applying heat (at a temperature inherent to the organic peroxide) or irradiating an active energy ray such as light or ionizing radiation.

The composition of the produced (co)polymer can be controlled by the composition of the starting monomers.

Also the molecular weight of the polymer can be controlled by the content of monomers to be used for the polymerization, the content of organic peroxide, the content of chain transfer agent and temperature.

The amount of the specific organic peroxide based on the monomers to be used is not less than 0.005 part by weight and not more than 10 parts by weight, preferably not less than 0.01 part by weight and not more than 5 parts by weight, more preferably not less than 0.1 part by weight and not more than 1 part by weight based on 100 parts by weight of the monomers. In another aspect, the amount of the organic peroxide is not less than 0.01 % by mole and not more than 10 % by mole, preferably not less than 0.05 % by mole and not more than 5 % by mole, more preferably not less than 0.1 % by mole and not more than 2 % by mole based on the molar amount of the monomers to be used.

If the amount of the organic peroxide is too small, the polymerization reaction does not advance enough, and therefore un-reacted monomers remain and oligomer components are produced, which are not preferred since coloring of the polymer and lowering of transparency occur. Too large amount of the organic peroxide is not preferred because lowering of molecular weight of the polymer arises, transparency is lowered and un-reacted organic peroxide remains, thereby causing coloring of the polymer and lowering of transparency.

The reaction temperature in the polymerization using the organic peroxide of the present invention as the radical polymerization initiator can be optionally selected depending on 10-hour half-life temperatures of the respective organic peroxides to be used and also depending on the intended reaction time. The reaction temperature is generally not less than 0°C and not more than 150°C, preferably not less than 5°C and not more than 120°C, more preferably not less than 10°C and not more than 100°C.

The monomer composition in the copolymerization may be selected according to polymerization reactivity and copolymerization ratio of each monomer and also properties to be imparted to the obtained fluorine-containing polymer. The properties which each monomer can impart to the fluorine-containing polymer are as mentioned supra and are concretely explained later.

The first fluorine-containing polymer obtained by the first preparation process of the present invention and the second and third fluorine-containing polymers for resist explained infra are fluorine-containing polymers represented by the formula (A):

-(M1)-(N1)-

wherein M1 is a structural unit derived from the monomer (m1) which can introduce an aliphatic ring structure to the polymer trunk chain and may have fluorine atom; N1 is a structural unit derived from the comonomer (n1) copolymerizable with the monomer (m1), and
the proportion of the structural unit (M1) to the structural unit (N1) is usually 100/0 to 10/90, preferably 80/20 to 20/80, particularly preferably 70/30 to 30/70.

Examples of the monomers (m1) and (n1) are those mentioned supra.

The second and third fluorine-containing polymers obtained by the second and third preparation processes of the present invention are high in transparency to light in a vacuum ultraviolet region having a wavelength of not more than 200 nm, and therefore, are resist polymers useful particularly for a photolithography process using ArF excimer laser (193 nm) or F2 laser (157 nm).

Further the present invention relates to a photoresist composition which comprises:
(A-1) a fluorine-containing polymer having at least one of acid-reactive groups Y¹ including OH group, an acid-labile functional group which can be converted to OH group by an acid, COOH group and an acid-labile functional group which can be converted to COOH group by dissociation with an acid,
(B) a photoacid generator, and
(C) a solvent,
in which the fluorine-containing polymer (A-1) is the polymer obtained by the second or third preparation process of the present invention.

In the photoresist composition of the present invention, the fluorine-containing polymer (A-1) having, as the acid-reactive functional group Y, at least one of specific acid-reactive groups Y¹, i.e. OH group, an acid-labile functional group which can be converted to OH group by an acid, COOH group and an acid-labile functional group which can be converted to COOH group by dissociation with an acid is used.

Examples of the acid-labile functional group which can be converted to OH group by an acid and the acid-labile functional group which can be converted to -COOH group by an acid are those mentioned supra.

Preferred as the fluorine-containing polymer (A-1) having the specific acid-reactive group Y¹ are the following polymers.
(I) Fluorine-containing polymers represented by the formula:

   -(M2)-(M3-2)-

   wherein M2 is a structural unit derived from the ethylenic monomer (m2) having two or three carbon atoms and at least one fluorine atom; M3-2 is a structural unit derived from the monomer (m3-2) which is a monocyclic aliphatic unsaturated hydrocarbon compound having the acid-reactive functional group Y¹ and may have fluorine atom.
   A percent by mole ratio of the structural unit (M2) to the structural unit (M3-2) is usually 80/20 to 20/80, preferably 70/30 to 30 / 70, particularly preferably 60 / 40 to 40/60.
   Examples of the monomers are preferably those exemplified supra as the monomers (m2) and (m3-2), in which the acid-reactive functional group Y is the acid-reactive group Y¹.
(II) Fluorine-containing polymers represented by the formula:

   -(M2)-(M3-4)-

   wherein M2 is as defined above; (M3-4) is a structural unit derived from the monomer (m3-4) which has an aliphatic polycyclic structure and the above-mentioned acid-reactive group Y¹, particularly a structural unit derived from a norbornene derivative.
   A percent by mole ratio of the structural unit (M2) to the structural unit (M3-4) is usually 80/20 to 20/80, preferably 70/30 to 30/70, particularly preferably 60/40 to 40/60.
   Examples of the monomers are preferably those exemplified supra as the monomers (m2) and (m3-4), in which the acid-reactive functional group Y is the acid-reactive group Y¹.
   Those fluorine-containing polymers (I) and (II) are excellent in transparency and dry etching resistance, and transparency in a vacuum ultraviolet region and developing characteristics can be improved further by the preparation process of the present invention using a specific polymerization initiator.
(III) Fluorine-containing polymers represented by the formula:

   -(M2)-(M3-1)-(N2-1)-

   wherein M2 is as defined above; (M3-1) is a structural unit derived from the monocyclic monomer (m3-1) which has a polymerizable carbon-carbon un-saturated bond in its ring structure and does not have the acid-reactive functional group Y; N2-1 is a structural unit derived from a copolymerizable ethylenic monomer (n2-1) having the acid-reactive group Y¹.
   With respect to proportions of the structural units (M2), (M3-1) and (N2-1), when (M2) + (M3-1) + (N2-1) is assumed to be 100 % by mole, a percent by mole ratio of ((M2) + (M3-1)) / (N2-1) is usually 90/ 10 to 20/80, preferably 80/20 to 30/70, particularly preferably 70/30 to 40/60.
   Examples of the monomers are preferably those exemplified supra as the monomers (m2), (m3-1) and (n2-1), in which the acid-reactive functional group Y is the acid-reactive group Y¹.
(IV) Fluorine-containing polymers represented by the formula:

   -(M2)-(M3-3)-(N2-1)-

   wherein M2 and N2-1 are as defined above; M3-3 is a structural unit derived from the monomer (m3-3) which has an aliphatic polycyclic structure and has no acid-reactive functional group Y, particularly a structural unit derived from a norbornene derivative. With respect to proportions of the structural units (M2), (M3-3) and (N2-1), when (M2) + (M3-3) + (N2-1) is assumed to be 100 % by mole, a percent by mole ratio of ((M2) + (M3-3))/(N2-1) is usually 90/10 to 20/80, preferably 80/20 to 30/70, particularly preferably 70/30 to 40/60.
   Examples of the monomers are preferably those exemplified supra as the monomers (m2), (m3-3) and (n2-1), in which the acid-reactive functional group Y is the acid-reactive group Y¹.
(V) Fluorine-containing polymers represented by the formula:

   -(M3-5)-(N2-1)-

   wherein N2-1 is as defined above; (M3-5) is a structural unit which has a ring structure on a trunk chain of the polymer and is obtained by cyclic polymerization of a non-conjugated divinyl compound.

A percent by mole ratio of the structural unit (M3-5) to the structural unit (N2-1) is usually 80/20 to 20/80, preferably 70/30 to 30/70, particularly preferably 60/40 to 40/60. When (M3-5) has Y¹, the ratio is usually 100/0 to 20/80, preferably 98/2 to 60/40, particularly preferably 95/5 to 80/20.

Examples of the monomers are preferably those exemplified supra as the monomers (m3-5) and (n2-1), in which the acid-reactive functional group Y is the acid-reactive group Y¹.

Those fluorine-containing polymers (III), (IV) and (V) are excellent in dry etching resistance, and transparency in a vacuum ultraviolet region and developing characteristics can be improved further by the preparation process of the present invention using a specific polymerization initiator.

Also the fluorine-containing polymers (I) to (V) having the acid-reactive group Y¹ are different from conventional fluorine-containing polymers for resist in the point that the former polymers have, at the initiation end of polymerization, an atomic group exhibiting small absorption of light in a vacuum ultraviolet region, and are excellent in transparency particularly in a vacuum ultraviolet region.

Further OH group can be introduced to the polymerization initiation end, and therefore hydrophilic property of the polymer is enhanced and the polymer is excellent in developing characteristics.

In the photoresist composition of the present invention, the fluorine-containing polymer (A-1) having the acid-reactive group Y¹ is excellent in transparency at a wavelength of 157 nm, and an absorption coefficient of the polymer at 157 nm is not more than 2.0 µm⁻¹, preferably not more than 1.5 µm⁻¹, particularly preferably not more than 1.0 µm⁻¹, further preferably not more than 0.5 µm⁻¹ though it is ideally zero. The fluorine-containing polymer is preferred since when the polymer is used for a F2 photoresist composition, a good resist pattern can be formed as the absorption coefficient at a wavelength of 157 nm decreases.

In the photoresist composition of the present invention, there are preferably the same examples of the photoacid generator (B) as those of the photoacid generator (B) raised in International Publication No. 01/74916. Those photoacid generators can also be used effectively in the present invention.

The photoacid generator is a compound which generates an acid or a cation by irradiation of light. Examples thereof are, for instance, organic halogen compounds, sulfonic acid esters, onium salts (particularly fluoroalkyl onium salts having iodine, sulfur, selenium, tellurium, nitrogen or phosphorus as a center element), diazonium salts, disulfone compounds, sulfonediazides and mixtures thereof.

More preferred examples thereof are as follows.

### (1) TPS compound:

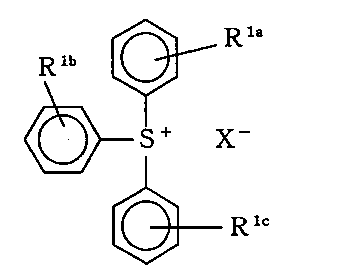

wherein X⁻ is PF₆⁻, SbF₆⁻, CF₃SO₃⁻, C₄F₉SO₃⁻ or the like; R^{1a}, R^{1b} and R^{1c} are the same or different and each is CH₃O H, t-Bu, CH₃, OH or the like.

### (2) DPI compound:

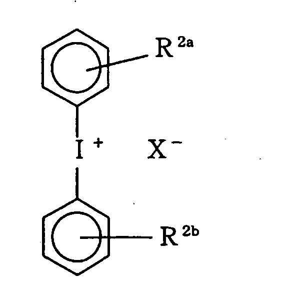

wherein X⁻ is CF₃SO₃⁻, C₄F₉SO₃⁻, CH₃-φ-SO₃⁻_{'} SbF₆⁻, 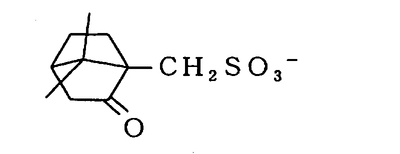 or the like; R^{2a} and R^{2b} are the same or different and each is H, OH, CH₃, CH₃O t-Bu or the like.

### (3) Sulfonate compound:

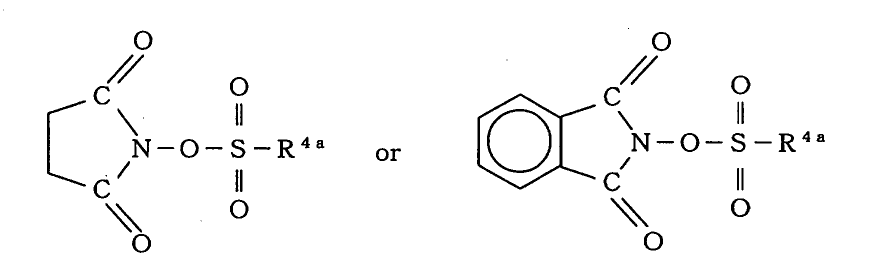

wherein R^{4a} is: 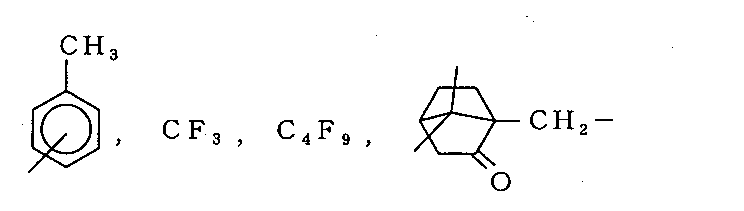 or the like.

The content of photoacid generator used for the photoresist composition of the present invention is preferably not less than 0.1 part by weight and not more than 30 parts by weight, more preferably not less than 0.2 part by weight and not more than 20 parts by weight, most preferably not less than 0.5 part by weight and not more than 10 parts by weight based on 100 parts by weight of the fluorine-containing polymer (A-1) having the acid-reactive group Y¹.

If the content of photoacid generator is lower than 0.1 part by weight, sensitivity is lowered, and if the content of photoacid generator is more than 30 parts by weight, an amount of light absorbed by the photoacid generator is increased and light does not reach a substrate sufficiently and therefore resolution tends to be lowered.

Also to the photoresist composition of the present invention may be added an organic base being capable of acting as a base on an acid generated from the photoacid generator. Examples of preferred organic base are the same as those exemplified in International Publication No. 01/74916. Those organic bases can also be used effectively in the present invention.

The organic base is an organic amine compound selected from nitrogen-containing compounds. Examples thereof are, for instance, pyridine compounds, pyrimidine compounds, amines substituted by a hydroxyalkyl group having 1 to 4 carbon atoms, amino phenols and the like. Particularly preferred are amines having hydroxyl group.

Examples thereof are butylamine, dibutylamine, tributylamine, triethylamine, tripropylamine, triamylamine, pyridine and the like.

The content of organic base in the photoresist composition of the present invention is preferably not less than 0.1 % by mole and not more than 100 % by mole, more preferably not less than 1 % by mole and not more than 50 % by mole based on the content of photoacid generator. If the content of organic base is lower than 0.1 % by mole, resolution is lowered, and if the content of organic base is more than 100 % by mole, sensitivity tends to be lowered.

The photoresist composition of the present invention may contain, as case demands, additives disclosed in International Publication No. 01/74916, for example, various additives which have been usually used in this field, such as dissolution inhibitor, sensitizer, dye, adhesion betterment material and water storage material.

Also in the photoresist composition of the present invention, examples of preferred solvent (C) are the same as those of the solvent (C) exemplified in International Publication No. 01 / 74916. Those solvents can also be used effectively in the present invention.

Preferred examples thereof are cellosolve solvents, ester solvents, propylene glycol solvents, ketone solvents, aromatic hydrocarbon solvents and solvent mixtures thereof. Also in order to enhance solubility of the fluorine-containing polymer (A-1), fluorine-containing solvents such as CH₃CCl₂F (HCFC-141b), fluorine-containing hydrocarbon solvents and fluorine-containing alcohols may be used together.

The amount of the solvent (C) is selected depending on kind of solids to be dissolved, kind of a substrate to be coated, an intended coating thickness, etc. From the viewpoint of easy coating, it is preferable that the solvent is used in such an amount that the concentration of the whole solids of the photoresist composition becomes not less than 0.5 % by weight and not more than 70 % by weight, preferably not less than 1 % by weight and not more than 50 % by weight.

The photoresist composition of the present invention can be used for a method of forming a resist pattern in conventional photoresist technology. Particularly in order to form a resist pattern properly, first, a solution of the photoresist composition is applied on a substrate such as a silicon wafer by a spinner or the like, and is dried to form a photosensitive layer. A pattern is drawn by irradiating the layer with ultraviolet ray, deep-UV, excimer laser or X-ray by a reduction projection exposure system, or the like through a proper mask pattern or the pattern is drawn with an electron beam, and then heating follows. The layer is then subjected to developing treatment with a developing solution, for example, an aqueous alkaline solution such as an aqueous solution of 1 to 10 % by weight of tetramethylammonium hydroxide. Thus an image faithful to the mask pattern can be obtained by this pattern forming method.

It was found that by using the photoresist composition of the present invention, a resist film (photosensitive layer) having a high transparency even in a vacuum ultraviolet region could be formed. Therefore the photoresist composition of the present invention can be preferably used particularly for a photolithography process using F2 laser (wavelength of 157 nm) which is under development aiming at a technology node of 0.07 µm.

The coating film of the photoresist of the present invention is formed by applying the above-mentioned photoresist composition on a substrate such as a silicon wafer by a spin coating method or the like, and then drying. In the coating film are contained solid components such as the fluorine-containing polymer (A-1) having an acid-reactive group, the photoacid generator (B) and in addition, additives.

The formed resist coating film is a thin film having a thickness of usually not more than 1.0 µm, preferably not less than 0.01 µm and not more than 0.5 µm, more preferably not less than 0.05 µm and not more than 0.5 µm.

The coating film obtained by applying the photoresist composition of the present invention is preferably one having high transparency in a vacuum ultraviolet region, and it is preferable that an absorption coefficient at 157 nm is not more than 2.5 µm⁻¹, preferably not more than 2.0 µm⁻¹, particularly preferably not more than 1.50 µm⁻¹, further preferably not more than 1.0 µm⁻¹. This coating film can be used effectively for a lithography process using F2 laser (157 nm).

For forming the resist coating film, there can be used similarly various substrates to which conventional resists are applied. For example, any of a silicon wafer, a silicon wafer on which an organic or inorganic antireflection film is provided, a glass substrate and the like may be used. Particularly when formed on a silicon wafer on which an organic antireflection film is provided, the resist coating film can have good sensitivity and profile.

The present invention is then explained by means of examples, but is not limited to them.

In the following Examples, physical properties are evaluated by using the following equipment and measuring conditions.
(1) NMR: AC-300 available from BRUKER CO., LTD.
   Measuring conditions of ¹H-NMR: 300 MHz (tetramethylsilane = 0 ppm) Measuring conditions of ¹⁹F-NMR: 300 MHz (trichlorofluoromethane = 0 ppm)
(2) IR analysis: Measuring is carried out at room temperature with a Fourier-transform infrared spectrophotometer 1760X available from Perkin Elmer Co., Ltd.
(3) GPC: A number average molecular weight is calculated from the data measured by gel permeation chromatography (GPC) by using GPC HLC-8020 available from Toso Kabushiki Kaisha and columns available from Shodex (one GPC KF-801, one GPC KF-802 and two GPC KF-806M were connected in series) and flowing tetrahydrofuran (THF) as a solvent at a flowing rate of 1 ml/min.

### EXPERIMENTAL EXAMPLE 1

### (Synthesis of copolymer comprising TFE and fluorine-containing norbornene derivative (NB-1) having OH group using PERHEXYL PV)

The inside of a 500 ml autoclave equipped with a valve, pressure gauge, stirrer and thermometer was replaced with nitrogen gas several times, followed by evacuation. Then the autoclave was charged with 15.0 g of fluorine-containing norbornene (NB-1) having -OH group: 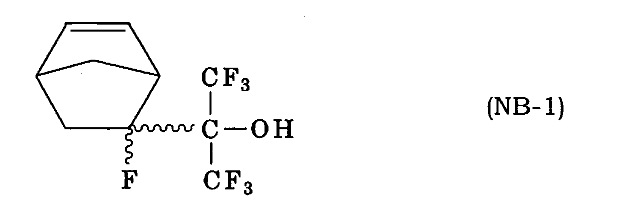 and 250 ml of a solution of HCFC-141b. Then 32.0 g of TFE was introduced through the valve and 0.71 g of toluene solution of 70 % by weight of PERHEXYL PV (t-hexylperoxypivalate) (following formula): 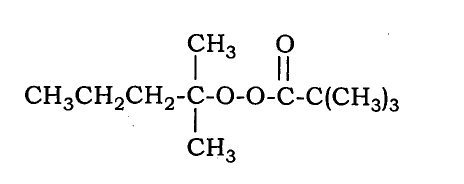 was introduced to carry out reaction at 60°C for three hours with stirring.

After the un-reacted monomer was released, the polymerization solution was taken out, followed by concentration and re-precipitation with hexane to separate a copolymer. Until a constant weight was reached, vacuum drying was continued and 2.4 g of copolymer was obtained.

As a result of ¹H-NMR and ¹⁹F-NMR analyses, the copolymer was a copolymer comprising TFE and the above-mentioned fluorine-containing norbornene derivative (NB-1) having OH group in a percent by mole ratio of 50/50.

According to GPC analysis, a number average molecular weight of the copolymer was 4,000, and a weight average molecular weight thereof was 4,800.

### EXPERIMENTAL EXAMPLE 2

### (Synthesis of copolymer comprising TFE and fluorine-containing norbornene derivative (NB-1) having OH group using PERHEXYL O)

Reaction was carried out in the same manner as in Experimental Example 1 except that 0.68 g of toluene solution of 90 % by weight of PERHEXYL O (t-hexylperoxy-2-ethylhexanoate) (following formula) : 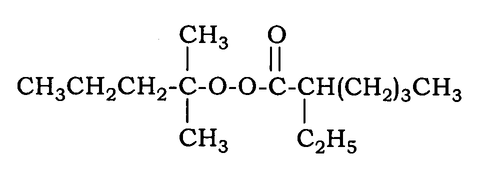 instead of PERHEXYL PV, 25.0 g of TFE and 14.0 g of NB-1 were used and the reaction was carried out at 75°C. Then re-precipitation with hexane, separation and refining were carried out in the same manner as in Experimental Example 1 to obtain 1.3 g of copolymer.

As a result of ¹H-NMR and ¹⁹F-NMR analyses, the copolymer was a copolymer comprising TFE and the above-mentioned fluorine-containing norbornene derivative (NB-1) having -OH group in a percent by mole ratio of 50/50.

According to GPC analysis, a number average molecular weight of the copolymer was 4,000, and a weight average molecular weight thereof was 4,600.

### EXPERIMENTAL EXAMPLE 3

### (Synthesis of copolymer comprising TFE and fluorine-containing norbornene derivative (NB-1) having OH group using PERBUTYL O)

The inside of a 500 ml autoclave equipped with a valve, pressure gauge, stirrer and thermometer was replaced with nitrogen gas several times, followed by evacuation. Then the autoclave was charged with 7.0 g of fluorine-containing norbornene derivative (NB-1) having - OH group: 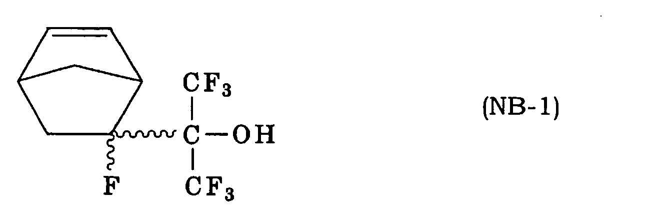 and 250 ml of a solution of HCFC-141b. Then 18.5 g of TFE was introduced through the valve and 0.27 g of PERBUTYL O (t-butylperoxy-2-ethylhexanoate) (following formula): 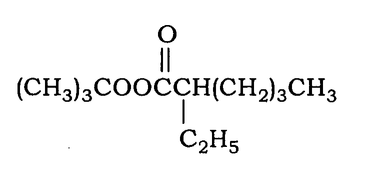 was introduced to carry out reaction at 80°C for three hours with stirring.

After the un-reacted monomer was released, the polymerization solution was taken out, followed by concentration and re-precipitation with hexane to separate a copolymer. Until a constant weight was reached, vacuum drying was continued and 1.5 g of copolymer was obtained.

As a result of ¹H-NMR and ¹⁹F-NMR analyses, the copolymer was a copolymer comprising TFE and the above-mentioned fluorine-containing norbornene derivative (NB-1) having OH group in a percent by mole ratio of 50/50.

According to GPC analysis, a number average molecular weight of the copolymer was 4,400, and a weight average molecular weight thereof was 5,800.

### EXPERIMENTAL EXAMPLE 4

### (Synthesis of copolymer comprising TFE and fluorine-containing norbornene derivative (NB-1) having OH group using PERCYCLO ND)

Reaction was carried out in the same manner as in Experimental Example 3 except that 1.3 g of toluene solution of 70 % by weight of PERCYCLO ND (1-cyclohexyl-1-methylethylperoxyneodecanoate) (following formula): 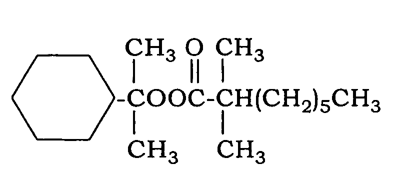 instead of PERBUTYL O, 43.0 g of TFE and 25.1 g of NB-1 were used and the reaction was carried out at 50°C. Then re-precipitation with hexane, separation and refining were carried out in the same manner as in Experimental Example 3 to obtain 2.0 g of copolymer.

As a result of ¹H-NMR and ¹⁹F-NMR analyses, the copolymer was a copolymer comprising TFE and the above-mentioned fluorine-containing norbornene derivative (NB-1) having -OH group in a percent by mole ratio of 50/50.

According to GPC analysis, a number average molecular weight of the copolymer was 4,400, and a weight average molecular weight thereof was 5,300.

### EXPERIMENTAL EXAMPLE 5

### (Synthesis of copolymer comprising TFE and fluorine-containing norbornene derivative (NB-1) having OH group using PERBUTYL PV)

Reaction was carried out in the same manner as in Experimental Example 3 except that 0.6 g of toluene solution of 70 % by weight of PERBUTYL PV (t-butylperoxypivalate) (following formula): 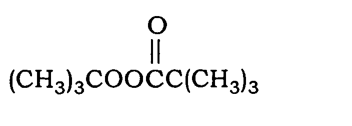 instead of PERBUTYL O, 38.0 g of TFE and 14.0 g of NB-1 were used and the reaction was carried out at 60°C. Then re-precipitation with hexane, separation and refining were carried out in the same manner as in Experimental Example 3 to obtain 1.8 g of copolymer.

As a result of ¹H-NMR and ¹⁹F-NMR analyses, the copolymer was a copolymer comprising TFE and the above-mentioned fluorine-containing norbornene derivative (NB-1) having -OH group in a percent by mole ratio of 50/50.

According to GPC analysis, a number average molecular weight of the copolymer was 4,500, and a weight average molecular weight thereof was 5,300.

### EXPERIMENTAL EXAMPLE 6

### (Synthesis of copolymer comprising TFE and fluorine-containing norbornene derivative (NB-1) having OH group using PEROYL 355)

Reaction was carried out in the same manner as in Experimental Example 3 except that 0.8 g of toluene solution of 75 % by weight of PEROYL 355 (3,5,5-trimethylhexanoylperoxide) (following formula) : 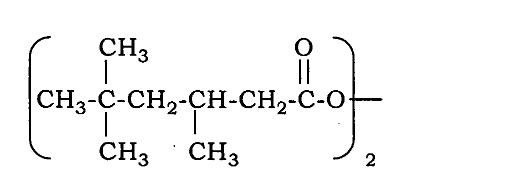 instead of PERBUTYL O, 30.0 g of TFE and 11.2 g of NB-1 were used and the reaction was carried out at 65°C. Then re-precipitation with hexane, separation and refining were carried out in the same manner as in Experimental Example 3 to obtain 0.8 g of copolymer.

As a result of ¹H-NMR and ¹⁹F-NMR analyses, the copolymer was a copolymer comprising TFE and the above-mentioned fluorine-containing norbornene derivative (NB-1) having -OH group in a percent by mole ratio of 50/50.

According to GPC analysis, a number average molecular weight of the copolymer was 4,700, and a weight average molecular weight thereof was 5,600.

### EXPERIMENTAL EXAMPLE 7

### (Synthesis of copolymer comprising TFE, fluorine-containing norbornene derivative (NB-1) having -OH group and fluorine-containing norbornene derivative (NB-1(1)) having -OCH₂OC₂H₅ group using PERHEXYL PV)

Reaction was carried out at 60°C in the same manner as in Experimental Example 1 except that 12 g of fluorine-containing norbornene derivative (NB-1) having -OH group, 3.7 g of fluorine-containing norbornene derivative (NB-1 (1)) having -OCH₂OC₂H₅ group: 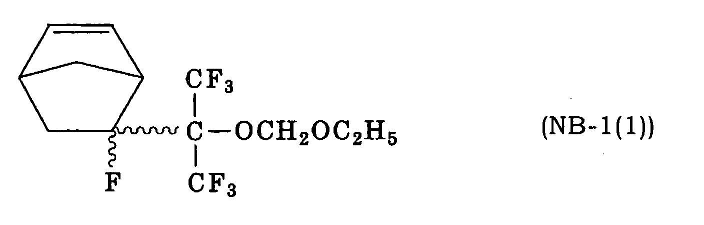 and 0.7 g of toluene solution of 70 % by weight of PERHEXYL PV were used. Then re-precipitation with hexane, separation and refining were carried out in the same manner as in Experimental Example 1 and 2.5 g of copolymer was obtained.

As a result of ¹H-NMR and ¹⁹F-NMR analyses, the copolymer was a copolymer comprising TFE, fluorine-containing norbornene derivative (NB-1) having -OH group and fluorine-containing norbornene derivative (NB-1(1)) having -OCH₂OC₂H₅ group in a percent by mole ratio of 50/40/10.

According to GPC analysis, a number average molecular weight of the copolymer was 3,500, and a weight average molecular weight thereof was 4,300.

### EXPERIMENTAL EXAMPLE 8

### (Synthesis of copolymer comprising TFE, fluorine-containing norbornene derivative (NB-1) having -OH group and fluorine-containing norbornene derivative (NB-1(1)) having -OCH₂OC₂H₅ group using PERCYCLO ND)

Reaction was carried out in the same manner as in Experimental Example 7 except that 1.3 g of toluene solution of 70 % by weight of PERCYCLO ND (1-cyclohexyl-1-methylethylperoxyneodecanoate) instead of PERHEXYL PV, 43.0 g of TFE, 20.0 g of NB-1 and 6.0 g of NB-1 (1) were used and the reaction was carried out at 50°C. Then re-precipitation with hexane, separation and refining were carried out in the same manner as in Experimental Example 1 to obtain 1.5 g of copolymer.

As a result of ¹H-NMR and ¹⁹F-NMR analyses, the copolymer was a copolymer comprising TFE, fluorine-containing norbornene derivative (NB-1) having -OH group and fluorine-containing norbornene derivative (NB-1(1)) having -OCH₂OC₂H₅ group in a percent by mole ratio of 50/40/10.

According to GPC analysis, a number average molecular weight of the copolymer was 3,400, and a weight average molecular weight thereof was 4,100.

### EXPERIMENTAL EXAMPLE 9

### (Synthesis of copolymer comprising TFE and fluorine-containing norbornene derivative (NB-1) having -OH group using peroxydicarbonate)

Reaction was carried out in the same manner as in Experimental Example 3 except that 6.5 g of PEROYL TCP (bis(4-t-butylcyclohexyl)peroxydicarbonate) (following formula): 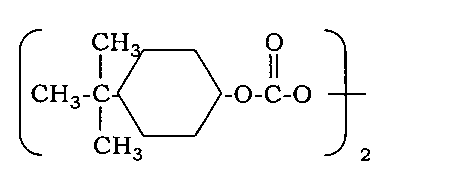 instead of PERBUTYL O, 52.0 g of TFE and 30.6 g of NB-1 were used and the reaction was carried out at 40°C. Then re-precipitation with hexane, separation and refining were carried out in the same manner as in Experimental Example 3 to obtain 3.0 g of copolymer.

As a result of analysis, the copolymer was a copoymer comprising TFE and the above-mentioned fluorine-containing norbornene derivative (NB-1) having -OH group in a percent by mole ratio of 50/50.

According to GPC analysis, a number average molecular weight of the copolymer was 3,000, and a weight average molecular weight thereof was 3,700.

### EXPERIMENTAL EXAMPLE 10

### (Synthesis of copolymer comprising TFE and fluorine-containing norbornene derivative (NB-1) having -OH group using diacyl peroxide having fluoroalkyl group)

Reaction was carried out in the same manner as in Experimental Example 3 except that 26.0 g of perfluorohexane solution of 8.0 % by weight of 7H-dodecafluoroheptanoylperoxide (following formula): 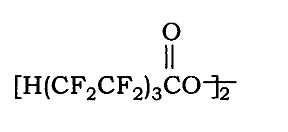 instead of PERBUTYL O, 80.0 g of TFE and 49.0 g of NB-1 were used and the reaction was carried out at 20°C. Then re-precipitation with hexane, separation and refining were carried out in the same manner as in Experimental Example 3 to obtain 3.0 g of copolymer.

As a result of analysis, the copolymer was a copolymer comprising TFE and the above-mentioned fluorine-containing norbornene derivative (NB-1) having -OH group in a percent by mole ratio of 50/50.

According to GPC analysis, a number average molecular weight of the copolymer was 4,100, and a weight average molecular weight thereof was 4,700.

### EXPERIMENTAL EXAMPLE 11

### (Determination of solubility in a developing solution)

A rate of dissolution was measured in the manner mentioned below by the quartz crystal oscillation method (QCM method) using the fluorine-containing polymers obtained in each Experimental Example.
(1) Production of sample: Solutions obtained by dissolving the fluorine-containing polymers prepared in each Experimental Example in PGMEA were applied on a 1 inch diameter quartz crystal oscillation panel coated with gold to make about 100 nm thick coating films.
(2) Measurement of rate of dissolution: A coating film thickness is calculated by converting the number of oscillations of the quartz crystal oscillation panel.

The above-mentioned quartz crystal oscillation panel coated with the fluorine-containing polymer was immersed in an aqueous solution of 2.38 % by weight of tetramethylammonium hydroxide (TMAH). A change in a coating film thickness with a lapse of time after the immersing was measured by a change in the number of oscillations and a rate of dissolution (nm/ sec) per unit time was calculated.

The results are shown in Table 1.

### EXPERIMENTAL EXAMPLE 12

### (Measurement of transparency at 157 nm)

### (1) Preparation of coating composition

The fluorine-containing polymers prepared in each Experimental Example were dissolved in butyl acetate so that the concentration thereof became 3 %, respectively. Thus each coating composition was prepared.

### (2) Coating

### (i) Coating on a substrate (MgF₂) for measuring transparency

Each coating composition was applied on a MgF₂ substrate at room temperature at 1,000 rpm with a spin coater, followed by baking at 100°C for 15 minutes to form transparent coating films.

### (ii) Measurement of coating thickness

Coating films were formed under the same conditions as above except that a silicon wafer was used instead of the MgF₂ substrate.

A coating thickness was measured with AFM equipment (SPI3800 available from Seiko Denshi Kabushiki Kaisha).

### (3) Measurement of transparency in vacuum ultraviolet region

### (i) Measuring device

- Setani-Namioka type spectrometer (BL-7B available from HIGH ENERGY KENKYU KIKO)
- Slit: 7/8 - 7/8
- Detector: PMT
- Grating (GII: Blaze wavelength 160 nm, 1,200 gratings/mm)

For an optical system, refer to Rev. Sic. Instrum., 60(7), 1917 (1989) by H. Namba, et al.

### (ii) Measurement of transmitting spectrum

A transmitting spectrum at a wavelength of 200 to 100 nm in a coating film formed by applying each coating composition on the MgF₂ substrate by the method of (2)(i) was measured using the above-mentioned device. Further a molecular absorption coefficient was calculated from the transmittance at 157 nm and the coating thickness and is shown in Table 1.

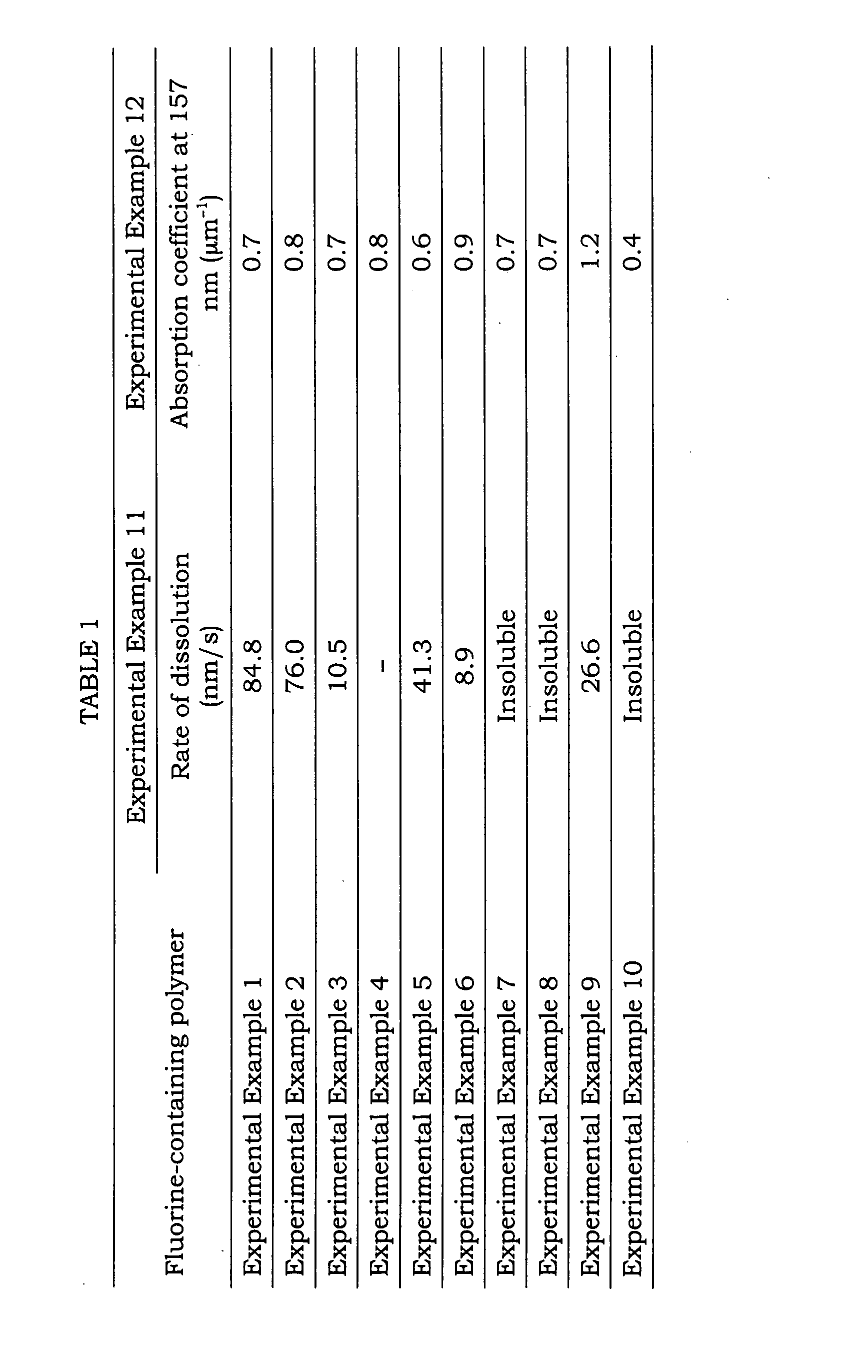

### EXAMPLE 13

### (Evaluation of solubility in developing solution)

### (1) Deprotection reaction of protective group

Each protective group contained in the fluorine-containing polymers of Experimental Examples 7 and 8 was subjected to deprotection by reacting the fluorine-containing polymers with trifluoroacetic acid by using dichloromethane solvent.

It was confirmed by ¹H-NMR and IR analyses that not less than 85 % of protective groups were deprotected and converted to OH groups.

### (2) Coating

5 % propylene glycol monomethyl ether acetate (PGMEA) solutions of deprotected fluorine-containing polymers obtained above were prepared and coated on a Si substrate with a spin coater so that a coating thickness became 200 nm, followed by drying.

### (3) Determination of solubility

The Si substrate after the drying was immersed in a 2.38 % aqueous solution of tetramethylammonium hydroxide for 60 seconds. Then the substrate was taken out and dried at room temperature, and whether or not there was a film remaining un-dissolved was checked with naked eyes.

When there remain no film, solubility is assumed to be ○. The results are shown in Table 2.

### EXPERIMENTAL EXAMPLE 14

### (1) Preparation of coating composition

The fluorine-containing polymers (A) prepared in Examples 7 and 8 and the photoacid generator (B) in an amount of 5 % by weight based on the polymer (A) were dissolved in propylene glycol monomethyl ether acetate (PGMEA) as the solvent (C) and a concentration of the polymer was diluted to 5 % by weight.

As the photoacid generator, S-(trifluoromethyl)-dibenzothiopheniumtrifluoromethane sulfonate: 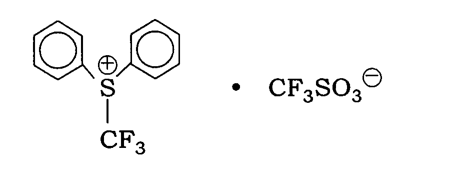 was used.

### (2) Coating

Coating compositions were coated on a Si substrate with a spin coater so that a coating thickness became 200 nm, followed by drying.

### (3) Measurement of transparency in vacuum ultraviolet region

Measurement was made in the same manner as in Experimental Example 12. A molecular absorption coefficient at 157 nm is shown in Table 2.

**TABLE 2**

| Fluorine-containing polymer | Experimental Example 13 | Experimental Example 14 |
|---|---|---|
| | Solubility after deprotection | Absorption coefficient of resist composition at 157 nm (µm⁻¹) |
| Experimental Example 7 | ○ | 0.9 |
| Experimental Example 8 | ○ | 1.0 |

### INDUSTRIAL APPLICABILITY

According to the preparation process of the present invention, the fluorine-containing polymer which is excellent in transparency in a vacuum ultraviolet region and can form an ultra fine pattern as a polymer for a photoresist, particularly for a F2 resist can be prepared.

## Claims

1. A process for preparing a fluorine-containing polymer having a structural unit (M1) derived from a monomer (m1) which provides an aliphatic ring structure in the polymer trunk chain and may have fluorine atom, in which said monomer (m1) being capable of providing an aliphatic ring structure in the polymer trunk chain is subjected to radical polymerization by using an organic peroxide having a structural unit represented by the formula (1-1): 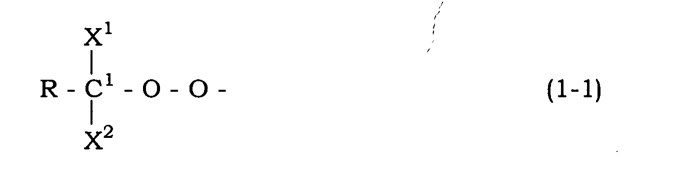 wherein R is selected from monovalent hydrocarbon groups having 3 or more carbon atoms, in which hydrogen atom may be substituted with fluorine atom or monovalent hydrocarbon groups having ether bond, in which the total number of carbon atoms and oxygen atoms is 3 or more and hydrogen atom may be substituted with fluorine atom, and when in R, carbon atoms or carbon atoms and oxygen atoms in the case of having ether bond are counted from the carbon atom C¹, at least one of the fourth atoms is a carbon atom to which at least one hydrogen atom is bonded; X¹ and X² are the same or different and each is hydrogen atom, halogen atom or a hydrocarbon group having 1 to 10 carbon atoms, in which a part or the whole of hydrogen atoms may be substituted with fluorine atoms,
or the formula (1-2): 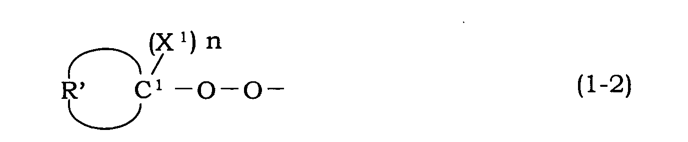 wherein R' is selected from divalent hydrocarbon groups having 4 or more carbon atoms, in which hydrogen atom may be substituted with fluorine atom or divalent hydrocarbon groups having ether bond, in which the total number of carbon atoms and oxygen atoms is 4 or more and hydrogen atom may be substituted with fluorine atom, and when in R', carbon atoms or carbon atoms and oxygen atoms in the case of having ether bond are counted from the carbon atom C¹, at least one of the fourth atoms is a carbon atom to which at least one hydrogen atom is bonded; X¹ is hydrogen atom, halogen atom or a hydrocarbon group having 1 to 10 carbon atoms, in which a part or the whole of hydrogen atoms may be substituted with fluorine atoms; n is 0 or 1.

2. The process for preparing a fluorine-containing polymer of Claim 1, wherein in R in the formula (1-1) and R' in the formula (1-2), when carbon atoms or carbon atoms and oxygen atoms are counted from the carbon atom C¹, at least one of atomic groups containing the fourth carbon atom is methyl group.

3. The process for preparing a fluorine-containing polymer of Claim 1, wherein R in the formula (1-1) is represented by the formula (1-1a): 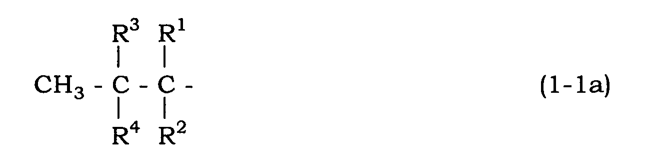 or the formula (1-2a): 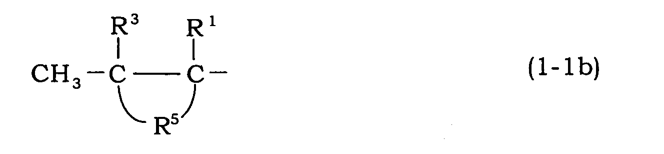 wherein R¹, R², R³ and R⁴ are the same or different and each is hydrogen atom or a hydrocarbon group having 1 to 10 carbon atoms, R⁵ is a divalent hydrocarbon group having 1 to 10 carbon atoms.

4. The process for preparing a fluorine-containing polymer of any of Claims 1 to 3, wherein the organic peroxide is at least one selected from oxyperesters, peroxy ketals, dialkyl peroxides and hydroperoxides.

5. The process for preparing a fluorine-containing polymer of any of Claims 1 to 4, wherein the structural unit (M1) derived from the monomer (m1) being capable of providing an aliphatic ring structure in the polymer trunk chain is a structural unit derived from a norbornene derivative which may have fluorine atom.

6. A process for preparing a fluorine-containing polymer for resist having excellent developing characteristics, which comprises a structural unit (M2) derived from a fluorine-containing ethylenic monomer (m2) having 2 or 3 carbon atoms and at least one fluorine atom and/or a structural unit (M3) derived from a monomer (m3) which can provide an aliphatic ring structure in the polymer trunk chain and may have fluorine atom, and has an acid-reactive group Y¹ reacting with an acid or a group Y² which can be converted to the acid-reactive group Y¹, said process is **characterized in that** the fluorine-containing ethylenic monomer (m2) and/or the monomer (m3) which can provide an aliphatic ring structure in the polymer trunk chain are subjected to radical polymerization by using the organic peroxide of any of Claims 1 to 4.

7. The preparation process of Claim 6, wherein the structural unit (M2) derived from the fluorine-containing ethylenic monomer (m2) is a structural unit derived from at least one monomer selected from tetrafluoroethylene, chlorotrifluoroethylene, vinylidene fluoride, vinyl fluoride and hexafluoropropylene.

8. The preparation process of Claim 6 or 7, wherein the structural unit (M3) derived from the monomer (m3) which can provide an aliphatic ring structure in the polymer trunk chain is a structural unit derived from a norbornene derivative which may have fluorine atom.

9. The preparation process of any of Claims 6 to 8, wherein said fluorine-containing ethylenic monomer (m2) and/or said monomer (m3) which can provide an aliphatic ring structure in the polymer trunk chain have the acid-reactive group Y¹ or the group Y² which can be converted to the acid-reactive group Y¹.

10. The preparation process of any of Claims 6 to 8, wherein the fluorine-containing polymer contains a repeat unit other than said repeat units (M2) and (M3) which is a repeat unit (N2-1) derived from a monomer (n2-1) having the acid-reactive group Y¹ or the group Y² which can be converted to the acid-reactive group Y¹, and further the monomer (n2-1) having the acid-reactive group Y¹ or the group Y² which can be converted to the acid-reactive group Y¹ in addition to said fluorine-containing ethylenic monomer (m2) and/or said monomer (m3) which can provide an aliphatic ring structure in the polymer trunk chain is subjected to radical polymerization.

11. The preparation process of Claim 9 or 10, wherein the fluorine-containing polymer which is prepared by radical polymerization using a polymerization initiator and has the group Y² which can be converted to the acid-reactive group Y¹ is subjected to polymer reaction to convert the group Y² to the acid-reactive group Y¹.

12. The preparation process of any of Claims 6 to 11, wherein the acid-reactive group Y¹ in the fluorine-containing polymer is at least one of OH group, an acid-labile functional group which can be converted to OH group by an acid, COOH group and an acid-labile functional group which can be converted to COOH group by dissociation with an acid.

13. A process for preparing a fluorine-containing polymer for resist which is excellent in transparency in a vacuum ultraviolet region, comprises a structural unit (M2) derived from a fluorine-containing ethylenic monomer (m2) having 2 or 3 carbon atoms and at least one fluorine atom and/or a structural unit (M3) derived from a monomer (m3) which can provide an aliphatic ring structure in the polymer trunk chain and may have fluorine atom, and contains an acid-reactive group Y¹ reacting with an acid or a group Y² which can be converted to the acid-reactive group Y¹, said process is **characterized in that** the fluorine-containing ethylenic monomer (m2) and/or the monomer (m3) which can provide an aliphatic ring structure in the polymer trunk chain are subjected to radical polymerization by using an organic peroxide represented by the formula (1): 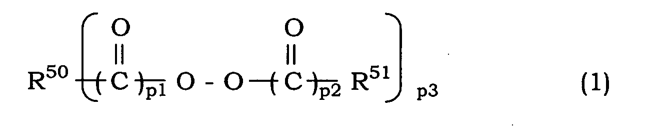 wherein R⁵⁰ and R⁵¹ are the same or different and each is a hydrocarbon group having 1 to 30 carbon atoms which may have ether bond (an atom at an end of bond is not an oxygen atom); p1and p2 are the same or different and each is 0 or 1; p3 is 1 or 2.

14. The preparation process of Claim 13, wherein the structural unit (M2) derived from the fluorine-containing ethylenic monomer (m2) is a structural unit derived from at least one monomer selected from tetrafluoroethylene, chlorotrifluoroethylene, vinylidene fluoride, vinyl fluoride and hexafluoropropylene.

15. The preparation process of Claim 13 or 14, wherein the structural unit (M3) derived from the monomer (m3) which can provide an aliphatic ring structure in the polymer trunk chain is a structural unit derived from a norbornene derivative which may have fluorine atom.

16. The preparation process of Claim 13 or 14, wherein the structural unit (M3) derived from the monomer (m3) which can provide an aliphatic ring structure in the polymer trunk chain is a structural unit of an aliphatic ring structure which may have fluorine atom.

17. The preparation process of any of Claims 13 to 16, wherein said fluorine-containing ethylenic monomer (m2) and/or said monomer (m3) which can provide an aliphatic ring structure in the polymer trunk chain have the acid-reactive group Y¹ or the group Y² which can be converted to the acid-reactive group Y¹.

18. The preparation process of any of Claims 1 to 17, wherein the fluorine-containing polymer contains a repeat unit other than said repeat units (M2) and (M3) which is a repeat unit (N2) derived from a monomer (n2) having the acid-reactive group Y¹ or the group Y² which can be converted to the acid-reactive group Y¹, and further the monomer (n2) having the acid-reactive group Y¹ or the group Y² which can be converted to the acid-reactive group Y¹ in addition to said fluorine-containing ethylenic monomer (m2) and/or said monomer (m3) which can provide an aliphatic ring structure in the polymer trunk chain is subjected to radical polymerization.

19. The preparation process of Claim 17 or 18, wherein the fluorine-containing polymer which is prepared by radical polymerization using the organic peroxide of the formula (1) and has the group Y² which can be converted to the acid-reactive group Y¹ is subjected to polymer reaction to convert the group Y² to the acid-reactive group Y¹.

20. The preparation process of any of Claims 13 to 19, wherein the acid-reactive group Y¹ in the fluorine-containing polymer is at least one of OH group, an acid-labile functional group which can be converted to OH group by an acid, COOH group and an acid-labile functional group which can be converted to COOH group by dissociation with an acid.

21. The preparation process of any of Claims 13 to 20, wherein in the organic peroxide of the formula (1), p3 is 1, one of p1 and p2 is 1 and one of R⁵⁰ and R⁵¹ is a hydrocarbon group which has 5 or more carbon atoms and may have ether bond.

22. The preparation process of any of Claims 13 to 20, wherein in the organic peroxide of the formula (1), p3 is 1, and p 1 and p2 are 1.

23. The preparation process of any of Claims 13 to 22, wherein at least one of R⁵⁰ and R⁵¹ in the organic peroxide of the formula (1) is a hydrocarbon group which has 5 or more carbon atoms and contains an aliphatic ring structure.

24. The preparation process of any of Claims 13 to 23, wherein at least one of R⁵⁰ and R⁵¹ in the organic peroxide of the formula (1) contains hydrophilic functional group.

25. The preparation process of Claim 24, wherein the hydrophilic functional group is at least one of OH group or COOH group.

26. A photoresist composition which provides a resist coating film being excellent in developing characteristics and comprises:
(A-1) a fluorine-containing polymer having at least one of acid-reactive groups Y¹ including OH group, an acid-labile functional group which can be converted to OH group by an acid, COOH group and an acid-labile functional group which can be converted to COOH group by dissociation with an acid,
(B) a photoacid generator, and
(C) a solvent,
in which said fluorine-containing polymer (A-1) is the polymer obtained by the preparation process of any of Claims 6 to 25.

27. The photoresist composition of Claim 26, wherein the fluorine-containing polymer (A-1) has an absorption coefficient of not more than 1.5 µm⁻¹ at a wavelength of 157 nm.
